# EUROPEAN PATENT APPLICATION

(11) **EP 4 734 693 A1**
(43) Date of publication of application: **29.04.2026**
(21) Application number: 25191555.9
(22) Date of filing: 24.07.2025
(51) Int. Cl.: H10B 12/00

(54) **SEMICONDUCTOR DEVICES AND METHOD OF MANUFACTURING THE SAME**

(30) Priority: 25.10.2024 KR 20240147931
(71) Applicant: Samsung Electronics Co., Ltd., Suwon-si, Gyeonggi-do 16677 (KR)
(72) Inventor: PARK, Sungmin, 16677 Suwon-si (KR); HAN, Jinwoo, 16677 Suwon-si (KR); KIM, Jeongsu, 16677 Suwon-si (KR); HAN, Seunguk, 16677 Suwon-si (KR)
(74) Representative: Marks & Clerk LLP

(57) **Abstract**

A semiconductor device includes a first stack structure including a first substrate, and a plurality of memory cells on the first substrate, and a second stack structure including a second substrate vertically overlapping the first substrate, and a plurality of peripheral circuit transistors on the second substrate, wherein the second stack structure includes a first via insulating layer passing through a part of the second substrate in a vertical direction, a second via insulating layer overlapping at least a portion of the first via insulating layer in the vertical direction and passing through other portions of the second substrate in the vertical direction, and a conductive through-via passing through the first via insulating layer and the second via insulating layer in the vertical direction.

## Description

### BACKGROUND

As miniaturization, multi-functionality, and high performance of electronic products are required, high-capacity semiconductor devices are required, and an increase in integration is required to provide high-capacity semiconductor devices. Accordingly, design rules for the configurations of semiconductor devices are reduced, and structures of the semiconductors are increasingly reduced. As the structures of the semiconductors are increasingly reduced, a method of providing a process margin with reliability is required.

### SUMMARY

In general, the present disclosure is directed toward a semiconductor device with improved reliability and a method of manufacturing the semiconductor device.

According to some implementations, the present disclosure is directed to a semiconductor device that includes a first stack structure including a first substrate, and a plurality of memory cells on the first substrate, and a second stack structure including a second substrate vertically overlapping the first substrate, and a plurality of peripheral circuit transistors on the second substrate, wherein the second stack structure includes a first via insulating layer passing through a part of the second substrate in a vertical direction, a second via insulating layer overlapping at least a portion of the first via insulating layer in the vertical direction and passing through other portions of the second substrate in the vertical direction, and a through-via passing through the first via insulating layer and the second via insulating layer in the vertical direction.

According to some implementations, the present disclosure is directed to a semiconductor device that includes a first stack structure including a first substrate, and a plurality of memory cells on the first substrate, and a second stack structure including a second substrate vertically overlapping the first substrate, and a plurality of peripheral circuit transistors on the second substrate, wherein the second stack structure includes a first via insulating layer arranged on a first surface of the second substrate, a second via insulating layer configured to be in contact with the first via insulating layer and arranged on a second surface of the second substrate opposite to the first surface, a through-via passing through the first via insulating layer and the second via insulating layer in the vertical direction, and a peripheral circuit wiring structure electrically connecting the plurality of peripheral circuit transistors to the through-via, a first horizontal width of the first via insulating layer decreases towards the second via insulating layer, and a second horizontal width of the second via insulating layer decreases towards the first via insulating layer.

According to some implementations, the present disclosure is directed to a method of manufacturing a semiconductor device that includes providing a first stack structure including a first substrate and a plurality of memory cells in the first substrate, and a second stack structure including a second substrate vertically overlapping the first substrate and a plurality of peripheral circuit transistors in the second substrate, and bonding the first stack structure to the second stack structure, wherein the providing of the second stack structure includes forming, on a first surface of the second substrate, a device isolation layer, which defines a plurality of active regions, and a first via insulating layer adjacent to the device isolation layer in a horizontal direction, and forming, on a second surface of the second substrate opposite to the first surface, a second via insulating layer in contact with the first via insulating layer.

According to some implementations, the forming of the first via insulating layer comprises: forming a first via trench by performing an anisotropic etching process on the first surface of the second substrate; and filling the first via trench with an insulating material.

According to some implementations, the forming of the device isolation layer and the first via insulating layer comprises: forming a device isolation trench and a first via trench by performing an anisotropic etching process on the first surface of the second substrate; and filling the device isolation trench and the first via trench with an insulating material.

According to some implementations, the forming of the second via insulating layer comprises: forming a second via trench by performing a dry etching process on the second surface of the second substrate to expose the first via insulating layer; and filling the second via trench with an insulating material.

According to some implementations, the bonding of the first stack structure to the second stack structure comprises: forming a first bonding insulating layer on the first stack structure and a second bonding insulating layer on the second stack structure; and bonding the first bonding insulating layer to the second bonding insulating layer.

According to some implementations, a method of manufacturing a semiconductor device further comprises forming a through-via passing through the first via insulating layer, the second via insulating layer, the first bonding insulating layer, and the second bonding insulating layer in the vertical direction after the bonding of the first stack structure to the second stack structure.

According to some implementations, the first stack structure includes a wiring structure on the plurality of memory cells, the second stack structure includes a peripheral circuit wiring structure on the plurality of peripheral circuit transistors, and the method further comprises forming a through-via electrically connecting the first wiring structure to the second wiring structure by passing through the first via insulating layer, the second via insulating layer, the first bonding insulating layer, and the second bonding insulating layer in the vertical direction after the step of bonding the first stack structure and the second stack structure.

According to some implementations, a method of manufacturing a semiconductor device further comprises forming a through-via passing through the first via insulating layer and the second via insulating layer in the vertical direction before the bonding of the first stack structure to the second stack structure.

According to some implementations, the bonding of the first stack structure to the second stack structure comprises: forming a plurality of first bonding pads on the first stack structure and a first bonding insulating layer surrounding sidewalls of the plurality of first bonding pads, and a plurality of second bonding pads on the second stack structure and a second bonding insulating layer surrounding sidewalls of the plurality of second bonding pads; and bonding the first stack structure to the second stack structure by respectively bonding the plurality of first bonding pads to the plurality of second bonding pads and bonding the first bonding insulating layer to the second bonding insulating layer, and the plurality of first bonding pads and the plurality of second bonding pads are electrically connected to the through-via.

According to some implementations, the providing of the second stack structure further comprises forming a bonding key for aligning the first stack structure with the second stack structure during a process of bonding the first stack structure to the second stack structure on the second via insulating layer after the forming of the second via insulating layer.

At least some of the above and other features of the invention are set out in the claims.

### BRIEF DESCRIPTION OF THE DRAWINGS

Example implementations will be more clearly understood from the following detailed description, taken in conjunction with the accompanying drawings.
FIG. 1 is a perspective view illustrating an example of a semiconductor device according to some implementations.
FIG. 2 is a circuit diagram illustrating an example of memory cell array of a semiconductor device according to some implementations.
FIG. 3 is a layout diagram illustrating an example of a partial region of a semiconductor device according to some implementations.
FIG. 4A is a cross-sectional view taken along line A1-A1' of FIG. 3 implementations.
FIG. 4B is a cross-sectional view taken along line B1-B1' of FIG. 3 according to some implementations.
FIG. 4C is a cross-sectional view taken along line C1-C1' of FIG. 3 according to some implementations.
FIG. 5 is an enlarged view of a region indicated as "EX1" of FIG. 4A according to some implementations.
FIG. 6A is a view illustrating an example of a semiconductor device according to some implementations.
FIG. 6B is a view illustrating an example of a semiconductor device according to some implementations.
FIG. 6C is a view illustrating an example of a semiconductor device according to some implementations.
FIG. 7 is a layout diagram illustrating an example of a partial region of a semiconductor device according to some implementations.
FIG. 8 is a cross-sectional view taken along line D1-D1' of FIG. 7 according to some implementations.
FIG. 9 is a layout diagram illustrating an example of a partial region of a semiconductor device according to some implementations.
FIG. 10 is a cross-sectional view taken along line E1-E1' of FIG. 9 according to some implementations.
FIG. 11A to FIG. 17B are views sequentially illustrating an example of a method of manufacturing a semiconductor device according to some implementations.
FIG. 18A to FIG. 19B are views sequentially illustrating an example of a method of manufacturing a semiconductor device according to some implementations.

### DETAILED DESCRIPTION

Hereinafter, example implementations will be explained in detail with reference to the accompanying drawings. The same reference numerals are used for the same components in the drawings, and redundant descriptions thereof are omitted.

Herein, a horizontal direction may include a first horizontal direction (the X direction) and a second horizontal direction (the Y direction) that intersect each other. A direction intersecting the first horizontal direction (the X direction) and the second horizontal direction (the Y direction) may be referred to as a vertical direction (the Z direction). Herein, a vertical level may be referred to as a height level according to a vertical direction (the Z direction) of a certain configuration.

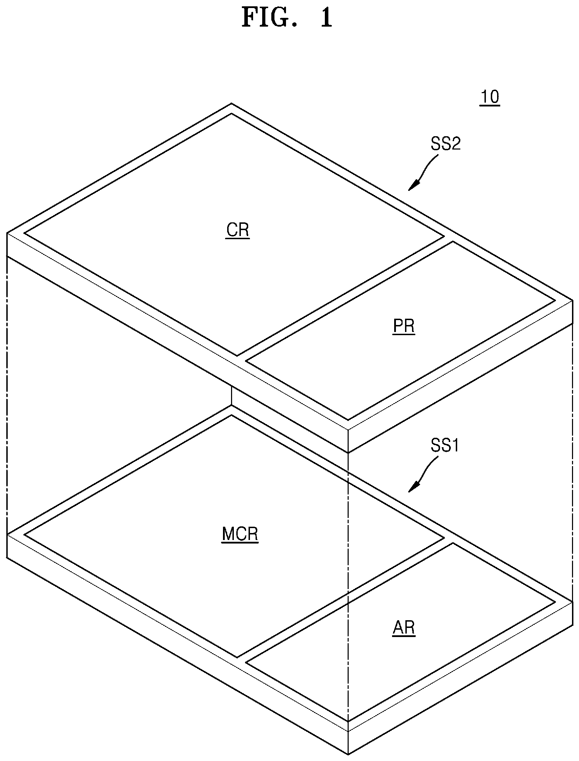

FIG. 1 is a perspective view illustrating an example of a semiconductor device according to some implementations. In FIG. 1, a semiconductor device 10 may have a structure in which a first stack structure SS1 and a second stack structure SS2 are stacked in a vertical direction. For example, the first stack structure SS1 and the second stack structure SS2 may be arranged at different vertical levels. Although FIG. 1 illustrates that the first stack structure SS1 is separated from the second stack structure SS2 for the sake of convenience of understanding, the semiconductor device 10 may have a structure in which a bottom surface of the second stack structure SS2 is attached to an upper surface of the first stack structure SS1.

The first stack structure SS1 may include a memory cell region MCR and an adjacent region AR. In some implementations, the memory cell region MCR may be a region in which a memory cell array is arranged. For example, bit lines, word lines, and memory cells may be arranged in the memory cell region MCR. In some implementations, the adjacent region AR may be a region in which wires connected to the memory cell region MCR are arranged. In some implementations, the adjacent region AR may be a region in which an anti-fuse cell array is arranged. For example, anti-fuse bit lines, anti-fuse word lines, and anti-fuse cells may be arranged in the adjacent region AR.

The second stack structure SS2 may include a core region CR and a peripheral circuit region PR. The core region CR may be arranged at a position overlapping the memory cell region MCR in a vertical direction (the Z direction) and may include various core circuits electrically connected to the memory cell region MCR. In some implementations, the core region CR may include a first core region and a second core region that are separated from each other, the first core region may include sense amplifiers which may be electrically connected to bit lines included in the first stack structure SS1, and the second core region may include sub-word line drivers which may be electrically connected to word lines included in the first stack structure SS1.

The peripheral circuit region PR may be arranged at a position overlapping the adjacent region AR in a vertical direction (the Z direction). The peripheral circuit region PR may include a first control signal generation circuit for controlling a sub-word line driver on the core region CR and a second control signal generation circuit for controlling a sense amplifier, and may further include the sense amplifier, the sub-word line driver, and so on. In some implementations, the peripheral circuit region PR may include an anti-fuse cell sensing circuit for controlling an anti-fuse cell array on the adjacent region AR and may further include a voltage generator for providing an operation voltage to the anti-fuse cell sensing circuit and so on.

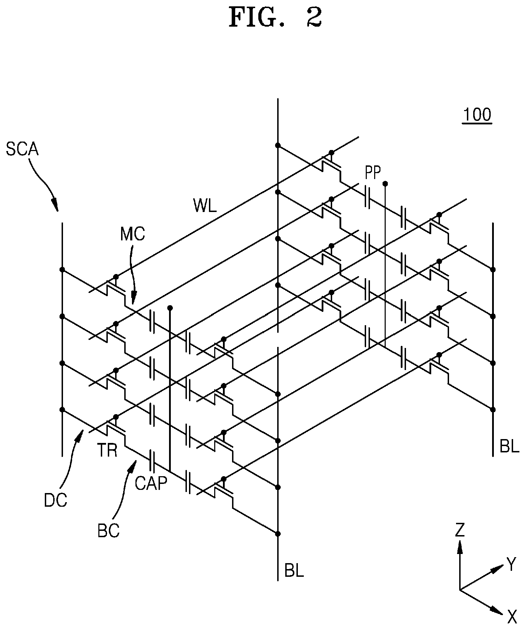

FIG. 2 is a circuit diagram illustrating an example of a memory cell array of a semiconductor device 100 according to some implementations. FIG. 2 illustrates the memory cell array including a plurality of sub-cell arrays SCA which may be arranged on the memory cell region MCR in FIG. 1. The plurality of sub-cell arrays SCA may be spaced apart from each other in a second horizontal direction (the Y direction).

The plurality of sub-cell arrays SCA may each include a plurality of bit lines BL, a plurality of word lines WL, and a plurality of memory cells MC. The plurality of memory cells MC may each include a transistor TR and a capacitor structure CAP connected to the transistor TR. The plurality of memory cells MC may each have one-transistor-one-capacitor (1T1C) structure.

The plurality of word lines WL may extend in a second horizontal direction (the Y direction) and may be spaced apart from each other in a first horizontal direction (the X direction) and a vertical direction (the Z direction). The plurality of bit lines BL may extend in a vertical direction (the Z direction) and may be spaced apart from each other in the first horizontal direction (the X direction) and the second horizontal direction (the Y direction). The transistor TR may be between the word line WL and the bit line BL.

A gate of the transistor TR may be connected to the word line WL, and a source of the transistor TR may be connected to the bit line BL via a first contact DC. The transistor TR may be connected to the capacitor structure CAP through a second contact BC. A drain of the transistor TR may be connected to a first electrode of the capacitor structure CAP through the second contact BC, and a second electrode of the capacitor structure CAP may be connected to a plate electrode PP.

In one sub-cell array SCA, the plurality of transistors TR may be arranged at positions where the plurality of transistors TR overlap each other in a vertical direction (the Z direction). In one sub-cell array SCA, a plurality of capacitor structures CAP may be arranged at positions where the plurality of capacitor structures CAP overlap each other in the vertical direction (the Z direction). 1T1C structures may be arranged side by side at the same vertical level, and the plurality of memory cells MC, each including 1T1C structure, may be stacked in a vertical direction (the Z direction). The storage capacity of the sub-cell array SCA may be changed depending on the number of memory cells MC stacked in the vertical direction (the Z direction) or the number of layers (for example, the number of capacitor structures CAP or the number of layers of capacitor structures CAP) of memory cells MC.

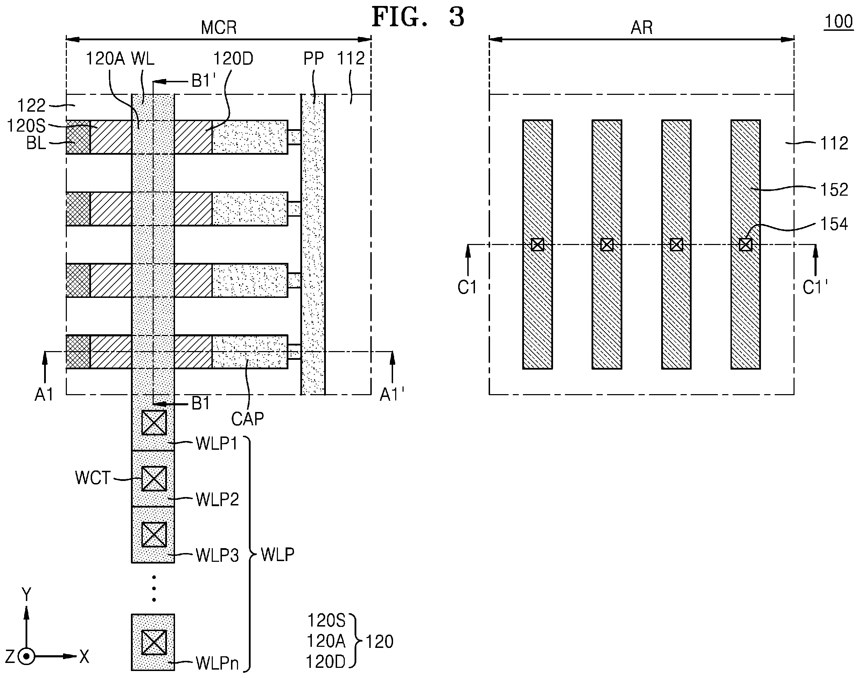

FIG. 3 is a layout diagram illustrating an example of a partial region of a semiconductor device according to some implementations.

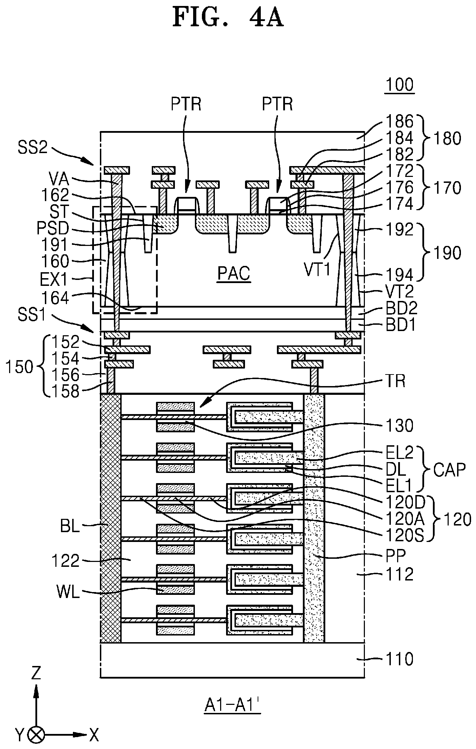

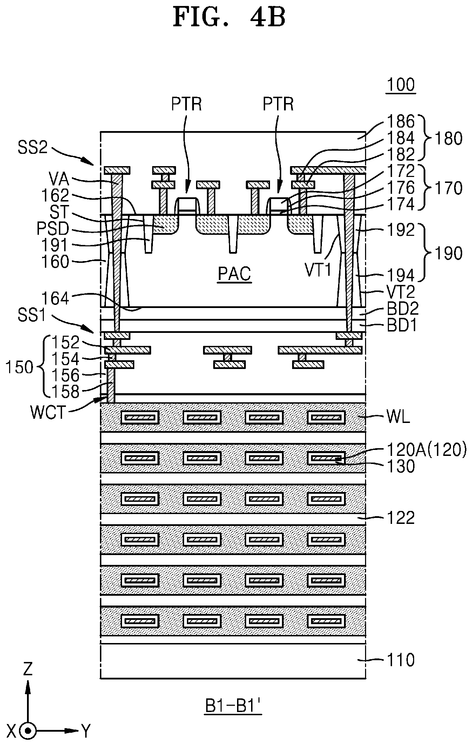

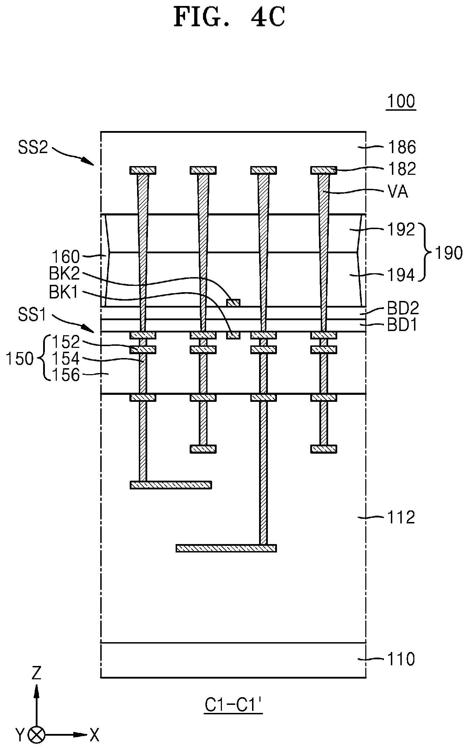

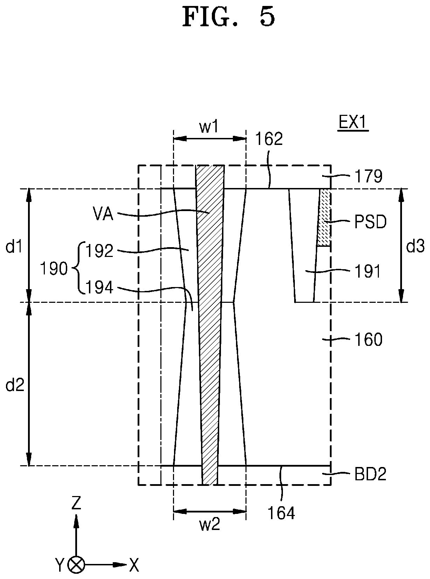

FIG. 4A is a cross-sectional view taken along line A1-A1' of FIG. 3 according to some implementations. FIG. 4B is a cross-sectional view taken along line B1-B1' of FIG. 3 according to some implementations. FIG. 4C is a cross-sectional view taken along line C1-C1' of FIG. 3 according to some implementations. FIG. 5 is an enlarged view of a region indicated as "EX1" of FIG. 4A according to some implementations.

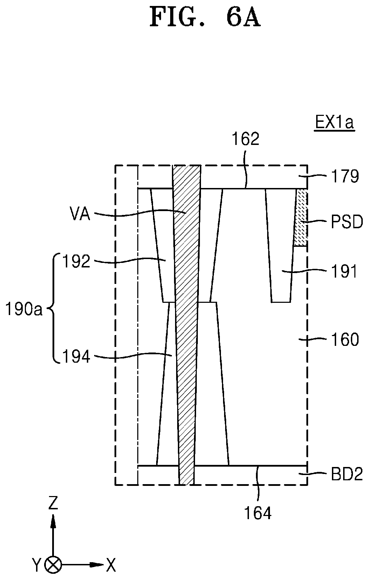

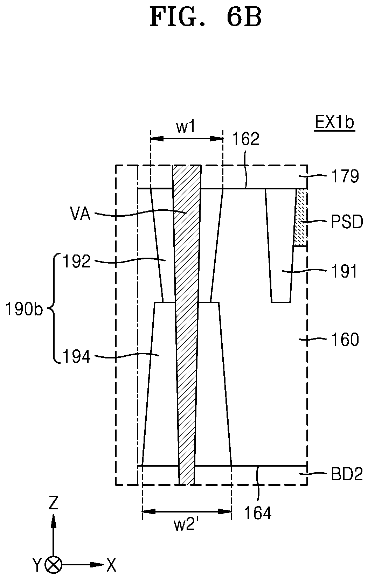

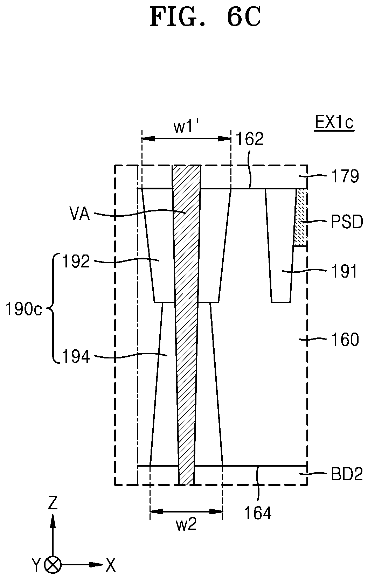

FIG. 6A is a view illustrating an example of a semiconductor device according to some implementations, FIG. 6B is a view illustrating an example of a semiconductor device according to some implementations, and FIG. 6C is a view illustrating a semiconductor device according to some implementations.

Specifically, FIG. 3 is a view illustrating an example of a partial region of the memory cell region MCR of the semiconductor device 100 according to some implementations, and an example of a partial region of the adjacent region AR of the semiconductor device 100 according to some implementations. The memory cell region MCR and the adjacent region AR of FIG. 3 may correspond to the memory cell region MCR and the adjacent region AR of FIG. 1.

In FIGS. 3, 4A, 4B, and 4C, the semiconductor device 100 may include a first stack structure SS1 and a second stack structure SS2, and the second stack structure SS2 may be bonded to the first stack structure SS1 by a first bonding insulating layer BD1 and a second bonding insulating layer BD2.

The first stack structure SS1 may include a first substrate 110, a plurality of semiconductor patterns 120 arranged on the first substrate 110, a plurality of bit lines BL, a plurality of word lines WL, and a capacitor structure CAP.

The first substrate 110 may include silicon (Si), germanium (Ge), or silicon-germanium (SiGe). In some implementations, the first substrate 110 may include a silicon-on-insulator (SOI) substrate or a germanium-on-insulator (GeOI) substrate.

The plurality of semiconductor patterns 120 may be arranged on the first substrate 110 to extend in a first horizontal direction (the X direction) and to be spaced apart in a vertical direction (the Z direction).

In some implementations, the plurality of semiconductor patterns 120 may each be formed of, for example, an undoped semiconductor material or a doped semiconductor material. In some implementations, the plurality of semiconductor patterns 120 may each be formed of polysilicon. In some implementations, the plurality of semiconductor patterns 120 may each include an amorphous metal oxide, a polycrystalline metal oxide, or a combination of the amorphous metal oxide and the polycrystalline metal oxide, and may each include at least one of, for example, an In-Ga-based oxide (IGO), an In-Zn-based oxide (IZO), or an In-Ga-Zn-based oxide (IGZO). In some implementations, the plurality of semiconductor patterns 120 may each include a two-dimensional (2D) material semiconductor, and the 2D material semiconductor may include, for example, MoS₂, WSe₂, graphene, carbon nanotubes, or a combination thereof.

The plurality of semiconductor patterns 120 may each have a line shape or a bar shape extending in the first horizontal direction (X direction). In some implementations, the plurality of semiconductor patterns 120 may each include a channel region 120A, a first impurity region 120S, and a second impurity region 120D, and the channel region 120A may be between the first impurity region 120S and the second impurity region 120D which are arranged in the first horizontal direction (the X direction). The first impurity region 120S may be connected to the bit line BL, and the second impurity region 120D may be connected to the capacitor structure CAP. An ohmic metal layer formed of a metal silicide or so on may be further provided between the first impurity region 120S and the bit line BL and between the second impurity region 120D and the capacitor structure CAP.

The word line WL may extend in a second horizontal direction (the Y direction) to intersect the first horizontal direction (the X direction), which is an extension direction of the plurality of semiconductor patterns 120. A word line pad WLP may be provided at an end of the word line WL. A plurality of word line pads WLP may be sequentially arranged in the second horizontal direction (the Y direction) and may be arranged in a stair shape in the second horizontal direction (the Y direction).

In some implementations, a word line pad WLPn connected to the n^{th} word line WL from the top may be arranged in the second horizontal direction (the Y direction). For example, a word line pad WLP1 connected to the word line WL at an uppermost portion, a second word line pad WLP2 connected to the word line WL below the word line WL at the uppermost portion, and a third word line pad WLP3 connected to the word line WL below the two word lines WL at the uppermost portion may be sequentially arranged in the second horizontal direction (the Y direction).

A plurality of word line contacts WCT may be respectively arranged on upper surfaces of the plurality of word line pads WLP, and a plurality of word lines WL may be respectively and electrically connected to wiring structures 150 respectively by the plurality of word line contacts WCT.

The plurality of word lines WL may include at least one of a doped semiconductor material (for example, doped silicon, doped germanium, or so on), a conductive metal nitride (for example, titanium nitride, tantalum nitride, or so on), a metal (for example, tungsten, titanium, tantalum, or so on), and a metal-semiconductor compound (for example, tungsten silicide, cobalt silicide, titanium silicide, or so on).

In some implementations, a gate insulating layer 130 may be provided between the word line WL and the semiconductor pattern 120. The gate insulating layer 130 may include at least one selected from a high-k dielectric material having a higher dielectric constant than silicon oxide and a ferroelectric material. In some implementations, the gate insulating layer 130 may include at least one selected from among hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (SBT), bismuth iron oxide (BFO), strontium titanium oxide (SrTiO), yttrium oxide (YO), aluminum oxide (AlO), and lead scandium tantalum oxide (PbScTaO).

In some implementations, a plurality of bit lines BL may extend in a vertical direction (the Z direction) on a first substrate 110 and spaced apart from each other in the second horizontal direction (the Y direction). The plurality of bit lines BL may include any one of a doped semiconductor material, a conductive metal nitride, a metal, and a metal-semiconductor compound.

The capacitor structure CAP may include a first electrode EL1, a capacitor dielectric layer DL, and a second electrode EL2. The first electrode EL1 may extend in the first horizontal direction (the X direction), and ends of the first electrode EL1 may be spaced apart from each other in a vertical direction (the Z direction). The first electrode EL1 may have an internal space (not illustrated) extending in the first horizontal direction (the X direction), and the internal space may be filled with the capacitor dielectric layer DL and the second electrode EL2. For example, the first electrode EL1 may have a cup shape rotated 90 degrees.

In some implementations, the capacitor dielectric layer DL may include at least one selected from a high-k dielectric material having a dielectric constant higher than silicon oxide and a ferroelectric material. In some implementations, the capacitor dielectric layer DL may include at least one selected from among hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), bismuth strontium tantalate (STB), bismuth iron oxide (BFO), strontium titanium oxide (SrTiO), yttrium oxide (YO), aluminum oxide (AlO), and lead scandium tantalum oxide (PbScTaO).

The second electrode EL2 may fill the internal space of the first electrode EL1, and the capacitor dielectric layer DL may be between the internal space of the first electrode EL1 and the second electrode EL2.

The first electrode EL1 and the second electrode EL2 may each include a doped semiconductor material, a conductive metal nitride, such as titanium nitride, tantalum nitride, niobium nitride, or tungsten nitride, a metal, such as ruthenium, iridium, titanium, or tantalum, or a conductive metal oxide, such as iridium oxide or niobium oxide.

In some implementations, a plate electrode PP may extend in the vertical direction (the Z direction) and the second horizontal direction (the Y direction) on one side of the capacitor structure CAP. The second electrode EL2 of the capacitor structure CAP may be electrically connected to the plate electrode PP, and, for example, a plurality of second electrodes EL2 spaced apart from each other in the vertical direction (the Z direction) and a plurality of second electrodes EL2 spaced apart from each other in the second horizontal direction (the Y direction) may be commonly connected to the plate electrode PP.

A filling insulating layer 112 may be provided on one side of the plate electrode PP. A mold insulating layer 122 may be provided between two adjacent first semiconductor patterns 120, between two adjacent word lines WL, between two adjacent first electrodes EL1, and between two adjacent bit lines BL.

The filling insulating layer 112 and the mold insulating layer 122 may each include silicon oxide, silicon oxynitride, silicon nitride, carbon-containing silicon oxide, carbon-containing silicon oxynitride, carbon-containing silicon nitride, or a combination thereof.

The mold insulating layer 122 may include a plurality of insulating layers. Here, insulating layers provided between a plurality of bit lines BL, between a plurality of word lines WL, between a plurality of first semiconductor patterns 120, and between a plurality of capacitor structures CAP according to a manufacturing process employed to form a three-dimensional structure may be collectively referred to as the mold insulating layer 122.

The first stack structure SS1 may include a wiring structure 150. For example, the wiring structure 150 may include a plurality of wiring layers 152, a plurality of vias 154, each electrically connecting two wiring layers 152 located at different vertical levels among the plurality of wiring layers 152, and an interlayer insulating layer 156 covering the plurality of wiring layers 152 and the plurality of vias 154. Also, the wiring structure 150 may further include a contact 158 electrically connected to the bit line BL, the word line WL, or the plate electrode PP.

The second stack structure SS2 may include a second substrate 160, a plurality of peripheral circuit transistors PTR on the second substrate 160, and a peripheral circuit wiring structure 180 covering the plurality of peripheral circuit transistors PTR on a first surface 162 of the second substrate 160. The transistor structures (PTR) shown in FIGS. 4A and 4B are schematically simplified for illustrative purposes to explain the gist of the present invention and may differ from the actual structure. In addition, the second stack structure SS2 may include a device isolation trench ST defining a plurality of ion implantation regions PSD on the second substrate 160, a device isolation layer 191 filling the device isolation trench ST, a first via insulating layer 192 filling a first via insulating layer trench VT1 in the second substrate 160, and a second via insulating layer 194 filling a second via insulating layer trench VT2, and herein, the first via insulating layer 192 and the second via insulating layer 194 may be collectively referred to as a via insulating layer 190.

The second substrate 160 may include silicon (Si), germanium (Ge), or silicon-germanium (SiGe) similarly to the first substrate 110. In some implementations, the second substrate 160 may include an SOI substrate, or a GeOI substrate.

The second substrate 160 may have a first surface 162 and a second surface 164 opposite the first surface 162, the first surface 162 of the second substrate 160 may be referred to as a front surface of the second substrate 160 or an upper surface of the second substrate 160, and the second surface 164 of the second substrate 160 may be referred to as a back surface of the second substrate 160 or a lower surface of the second substrate 160.

The plurality of peripheral circuit transistors PTR may each include a gate structure 170, and the gate structure 170 may include a gate electrode 172, a gate insulating layer 174, and a gate spacer 176 on an active region PAC of a second substrate 160. The plurality of peripheral circuit transistors PTR may each include a plurality of ion implantation regions PSD which are formed in the active region PAC and arranged on both sides of the gate structure 170. The plurality of ion implantation regions PSD may each constitute a source region or a drain region of each of the plurality of peripheral circuit transistors PTR.

The plurality of peripheral circuit transistors PTR may respectively include a plurality of sense amplifiers, and the plurality of sense amplifiers may be electrically connected to a plurality of bit lines BL included in the first stack structure SS1. Also, the plurality of peripheral circuit transistors PTR may include a plurality of sub-word line drivers, and the plurality of sub-word line drivers may be electrically connected to a plurality of word lines WL included in the first stack structure SS1. The plurality of peripheral circuit transistors PTR illustrated in FIG. 4A and FIG. 4B are schematically illustrated for the sake of convenience of illustration, and the plurality of peripheral circuit transistors PTR may each include any one of various devices, such as a planar transistor, a fin field-effect transistor (Fin FET), a multi-bridge channel field-effect transistor (MBC FET), or a gate-all-around field-effect transistor (GAA FET).

The peripheral circuit wiring structure 180 may include a plurality of wiring layers 182, a plurality of vias 184 respectively and electrically connecting the plurality of peripheral circuit transistors PTR to the plurality of wiring layers 182 or the plurality of wiring layers 182, which are provided at different vertical levels, to each other, and a peripheral circuit insulating layer 186 covering the plurality of wiring layers 182 and the plurality of vias 184.

Although it is illustrated that the peripheral circuit wiring structure 180 includes two wiring layers 182 in a vertical direction (the Z direction), the present disclosure is not limited thereto, and for example, the peripheral circuit wiring structure 180 may include three or more wiring layers 182.

At least some of each of the plurality of conductive components included in the wiring structure 150 of the first stack structure SS1 and the plurality of conductive components included in the peripheral circuit wiring structure 180 of the second stack structure SS2 may be respectively and electrically connected to the plurality of peripheral circuit transistors PTR.

The plurality of wiring layers 152 and the plurality of vias 154 included in the wiring structure 150 of the first stack structure SS1 and the plurality of wiring layers 182 and the plurality of vias 184 included in the peripheral circuit wiring structure 180 of the second stack structure SS2 may each include molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but are not limited thereto.

The interlayer insulating layer 156 of the first stack structure SS1 and the peripheral circuit insulating layer 186 of the second stack structure SS2 may each include an oxide layer, a nitride layer, an ultralow-k (ULK) layer having an ultralow dielectric constant K of about 2.2 to about 2.4, or a combination thereof. For example, the interlayer insulating layer 156 of the first stack structure SS1 and the peripheral circuit insulating layer 186 of the second stack structure SS2 may each include a tetraethylorthosilicate (TEOS) layer, a high density plasma HDP oxide layer, a boro-phospho-silicate glass (BPSG) layer, a flowable chemical vapor deposition (FCVD) oxide layer, a SiON layer, a SiN layer, a SiOC layer, a SiCOH layer, or a combination thereof but are not limited thereto.

In some implementations, the device isolation layer 191 may include an insulating material, and the insulating material may include silicon oxide, silicon nitride, or a combination thereof. For example, the insulating material may include fluoride silicate glass (SG), undoped silicate glass (USG), BPSG, phospho-silicate glass (PSG), flowable oxide (FOX), plasma enhanced tetra-ethyl-ortho-silicate (PE-TEOS), or tonen silazene (TOSZ) but is not limited thereto. The device isolation layer 191 may be configured as a single layer formed of one type of insulating layer, a double layer made of two types of insulating layers or a multilayer formed of a combination of at least three types of insulating layers. In some implementations, the device isolation layer 191 may have a shallow trench isolation (STI) structure.

The via insulating layer 190 may include a first via insulating layer 192 provided on the first surface 162 of the second substrate 160, and the second via insulating layer 194 provided on the second surface 164 of the second substrate 160 and overlapping the first via insulating layer 192 in the vertical direction (the Z direction). The first via insulating layer 192 may have a structure in which an insulating material is filled in the first via insulating layer trench VT1 extended from the first surface 162 of the second substrate 160, and the second via insulating layer 194 may have a structure in which an insulating material is filled in the second via insulating layer trench VT2 extended from the second surface 164 of the second substrate 160. The first via insulating layer 192 may be spaced apart from the first stack structure SS1 with the second via insulating layer 194 therebetween, and the second via insulating layer 194 may face the first stack structure SS1. In some implementations, the first via insulating layer 192 and the second via insulating layer 194 may each have a an STI structure.

In FIG. 5, the first via insulating layer 192 and the second via insulating layer 194 may each have an inclined sidewall, and the via insulating layer 190 may have an hourglass shape including the first via insulating layer 192, which may have a trapezoidal shape, and the second via insulating layer 194, which may have a trapezoidal shape. For example, the via insulating layer 190 may have a portion of which the horizontal width decreases and a portion of which the horizontal width increases as the via insulating layer 190 extends in the vertical direction (the Z direction). For example, the via insulating layer 190 may include a first portion of which the horizontal width decreases towards the second surface 164 of the second substrate 160, and a second portion of which the horizontal width decreases towards the second surface 164, and the first portion may correspond to the first via insulating layer 192, and the second portion may correspond to the second via insulating layer 194. For example, the via insulating layer 190 may include a third portion of which the horizontal width is the smallest between the first portion and the second portion.

In some implementations, a first horizontal width w1 of the first via insulating layer 192 may decrease towards the second via insulating layer 194, and a second horizontal width w2 of the second via insulating layer 194 may decrease towards the first via insulating layer 192. That is, the first horizontal width w1 of the first via insulating layer 192 and the second horizontal width w2 of the second via insulating layer 194 may increase or decrease in the vertical direction (the Z direction), a direction in which the first horizontal width w1 of the first via insulating layer 192 increases may be opposite to a direction in which the second horizontal width w2 of the second via insulating layer 194 increases, and a direction in which the first horizontal width w1 of the first via insulating layer 192 decreases may be opposite to a direction in which the second horizontal width w2 of the second via insulating layer 194 decreases.

The first via insulating layer 192 and the second via insulating layer 194 may each have a sidewall that is inclined at a less degree of slope than a degree of slope of a sidewall of a through-via VA with respect to the second surface 164 of the second substrate 160. The first via insulating layer 192 and the second via insulating layer 194 may be formed respectively in the first via insulating layer trench VT1 and the second via insulating layer trench VT2 formed by etching the second substrate 160, the through-via VA may be formed in a space formed by etching the first via insulating layer 192 and the second via insulating layer 194, and a difference in the degree of slope may occur due to a difference between a constituent material of the second substrate 160, which is a target of etching, and constituent materials of the first via insulating layer 192 and the second via insulating layer 194.

In some implementations, a first vertical height d1 of the first via insulating layer 192 may be different from a second vertical height d2 of the second via insulating layer 194. For example, the second vertical height d2 of the second via insulating layer 194 may be greater than the first vertical height d1 of the first via insulating layer 192. Alternatively, for example, the second vertical height d2 of the second via insulating layer 194 may be less than the first vertical height d1 of the first via insulating layer 192. In some implementations, the first vertical height d1 of the first via insulating layer 192 may be equal to the second vertical height d2 of the second via insulating layer 194.

The first vertical height d1 of the first via insulating layer 192 may be equal to a third vertical height d3 of the device isolation layer 191. In some implementations, the first via insulating layer 192 may include the same material as the device isolation layer 191. In some implementations, the first via insulating layer 192 may be formed by the same etching process and the same insulating material deposition process as the device isolation layer 191 and may be formed simultaneously with the device isolation layer 191.

In FIG. 5, in some implementations, a lower surface of the first via insulating layer 192 may be aligned to entirely overlap an upper surface of the second via insulating layer 194, but the inventive concept is not limited thereto.

In some implementations, as illustrated in FIG. 6A, the lower surface of the first via insulating layer 192 may be aligned to at least partially overlap the upper surface of the second via insulating layer 194. For example, the upper surface of the second via insulating layer 194 may not entirely overlap the lower surface of the first via insulating layer 192, and the lower surface of the first via insulating layer 192 may at least partially overlap the upper surface of the second via insulating layer 194 such that the upper surface of the second via insulating layer 194 is misaligned with the lower surface of the first via insulating layer 192 in the first horizontal direction (the X direction), the second horizontal direction (the Y direction), or a diagonal direction between the first horizontal direction (the X direction) and the second horizontal direction (the Y direction). In this case, a sidewall of the first via insulating layer 192 may not be continuously connected to a sidewall of the second via insulating layer 194, and instead, the sidewall of the first via insulating layer 192 may be spaced apart from the sidewall of the second via insulating layer 194.

In FIG. 6A, the second via insulating layer 194 may be misaligned with the first via insulating layer 192, and accordingly, the through-via VA may penetrate the other region instead of a central region of the second via insulating layer 194, and the first via insulating layer 192 may be misaligned with the second via insulating layer 194, and accordingly, the through-via VA may penetrate the other region instead of a central region of the first via insulating layer 192.

However, when the second via insulating layer 194 is misaligned with the first via insulating layer 192 and when the first via insulating layer 192 is misaligned with the second via insulating layer 194, the through-via VA may not be in contact with the second substrate 160, may be spaced apart from the second substrate 160 with the first via insulating layer 192 and the second via insulating layer 194 therebetween, and may be electrically insulated from the second substrate 160.

Also, in FIG. 5, the lower surface of the first via insulating layer 192 may have the same area as the upper surface of the second via insulating layer 194. For example, the smallest value of the first horizontal width w1 of the first via insulating layer 192 may be equal to the smallest value of the second horizontal width w2 of the second via insulating layer 194, but the present disclosure is not limited thereto.

In some implementations, as illustrated in FIG. 6B, the upper surface of the second via insulating layer 194 may have a greater area than the lower surface of the first via insulating layer 192, or, as illustrated in FIG. 6C, the upper surface of the second via insulating layer 194 may have a less area than the lower surface of the first via insulating layer 192. That is, as illustrated in FIG. 6B, the smallest value of a second horizontal width w2' of the second via insulating layer 194 may be greater than the smallest value of the first horizontal width w1 of the first via insulating layer 192, and as illustrated in FIG. 6C, the smallest value of the second horizontal width w2 of the second via insulating layer 194 may be less than the smallest value of a first horizontal width w1' of the first via insulating layer 192.

In this case, a sidewall of the first via insulating layer 192 may not be continuously connected to a sidewall of the second via insulating layer 194, and instead, the sidewall of the first via insulating layer 192 may be spaced apart from the sidewall of the second via insulating layer 194. For example, as illustrated in FIG. 6B, the sidewall of the second via insulating layer 194 may be spaced apart from the sidewall of the first via insulating layer 192 in the first horizontal direction (the X direction) and the second horizontal direction (the Y direction) with a part of the upper surface of the second via insulating layer 194 therebetween. For example, as illustrated in FIG. 6C, the sidewall of the first via insulating layer 192 may be spaced apart from the sidewall of the second via insulating layer 194 in the first horizontal direction (the X direction) and the second horizontal direction (the Y direction) with a part of the lower surface of the first via insulating layer 192 therebetween.

In some implementations, the first via insulating layer 192 and the second via insulating layer 194 may each include, for example, an insulating material, and the insulating material may include, for example, silicon oxide, silicon nitride, or a combination thereof. For example, the insulating material may include FSG, USG, BPSG, PSG, FOX, PE-TEOS, or TOSZ but is not limited thereto. The first via insulating layer 192 and the second via insulating layer 194 may each be configured with a single layer including one type of insulating layer, a dual layer including two types of insulating layers, or a multilayer including a combination of at least three types of insulating layers.

In some implementations, the first via insulating layer 192 may include the same material as the second via insulating layer 194. For example, the first via insulating layer 192 and the second via insulating layer 194 may each include silicon oxide. In some implementations, the first via insulating layer 192 may include different materials from the second via insulating layer 194.

In some implementations, the first stack structure SS1 may be bonded to the second stack structure SS2 through a first bonding insulating layer BD1 and a second bonding insulating layer BD2 bonded together. For example, the first stack structure SS1 may be bonded to the second stack structure SS2 through fusion bonding of the first bonding insulating layer BD1 and the second bonding insulating layer BD2. The first bonding insulating layer BD1 and the second bonding insulating layer BD2 may each include, for example, a silicon oxide layer. The first bonding insulating layer BD1 and the second bonding insulating layer BD2 may be integrally bonded together.

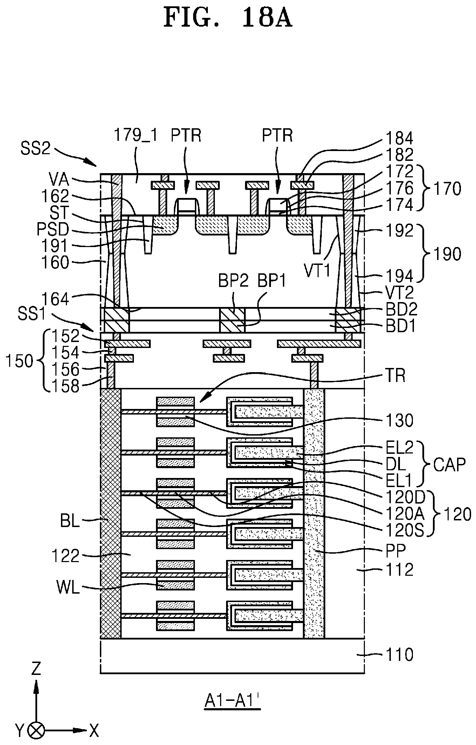

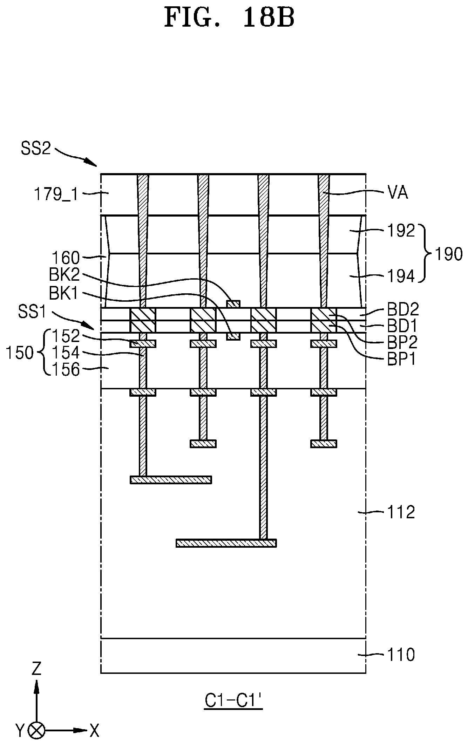

In some implementations, the first stack structure SS1 may be bonded to the second stack structure SS2 through bonding of the first bonding insulating layer BD1 and the second bonding insulating layer BD2, and through bonding of a plurality of first bonding pads having sidewalls surrounded by the first bonding insulating layer BD1 and a plurality of second bonding pads having sidewalls surrounded by the second bonding insulating layer BD2. The plurality of first bonding pads and the plurality of second bonding pads may each include copper, aluminum, or tungsten but are not limited thereto. A method of bonding the plurality of first bonding pads and the plurality of second bonding pads may be specifically described below with reference to FIG. 18A and FIG. 18B.

In FIG. 4C, the first stack structure SS1 may include a first bonding key BK1 to be aligned with the second stack structure SS2 during a process of bonding the first stack structure SS1 to the second stack structure SS2. Similarly, the second stack structure SS2 may include a second bonding key BK2 to be aligned with the first stack structure SS1 during the process of bonding the first stack structure SS1 to the second stack structure SS2. The first bonding key BK1 may be provided in an upper portion of an interlayer insulating layer 156 of the first stack structure SS1 to be in contact with a lower surface of the first bonding insulating layer BD1, and the second bonding key BK2 may be provided in an upper portion of a via insulating layer 190 (for example, the second via insulating layer 194) of the second stack structure SS2 to be in contact with an upper surface of the second bonding insulating layer BD2. The first bonding key BK1 may be surrounded by the first bonding insulating layer BD1 and the interlayer insulating layer 156, and the second bonding key BK2 may be surrounded by the second bonding insulating layer BD2 and the via insulating layer 190 (for example, the second via insulating layer 194). In some implementations, the first bonding key BK1 and the second bonding key BK2 may each include a different material from a surrounding configuration to be distinguished from the surrounding configuration, and for example, the first bonding key BK1 may include a different material from the interlayer insulating layer 156, and the second bonding key BK2 may include a different material from the second via insulating layer 194. For example, the first bonding key BK1 and the second bonding key BK2 may each include a conductive material, such as a metal.

In some implementations, the second stack structure SS2 may include a through-via VA that extends in a vertical direction (the Z direction) through the first via insulating layer 192 and the second via insulating layer 194 as illustrated in FIG. 4A, FIG. 4B, and FIG. 4C. The through-via VA may pass through a part of the peripheral circuit insulating layer 186, the via insulating layer 190, and a bonding interface between the first stack structure SS1 and the second stack structure SS2, and may pass through the first bonding insulating layer BD1 and the second bonding insulating layer BD2 in the vertical direction (the Z direction). One end of the through-via VA may be electrically connected to a wiring layer 182 of the peripheral circuit wiring structure 180 in the second stack structure SS2, and the other end of the through-via VA may be electrically connected to the wiring layer 152 of the wiring structure 150 in the first stack structure SS1. Through the through-via VA, the plurality of peripheral circuit transistors PTR of the second stack structure SS2 may each be electrically connected to the bit line BL or the word lines WL of the first stack structure SS1.

In some implementations, the second stack structure SS2 may further include an interlayer wiring layer (not illustrated) on the second surface 164 of the second substrate 160. For example, one end of the through-via VA may be electrically connected to the interlayer wiring layer (not illustrated) and the peripheral circuit wiring structure 180 of the second stack structure SS2, and the other end of the through-via VA may be electrically connected to the wiring layer 152 of the wiring structure 150 of the first stack structure SS1. In this case, as illustrated in FIG. 18A, the interlayer wiring layer (not illustrated) may be electrically connected to a second bonding pad BP2, and the wiring layer 150 may be electrically connected to a first bonding pad BP1. In the first stack structure SS1 and the second stack structure SS2 bonded to each other through the first bonding pad BP1 and the second bonding pad BP2, the plurality of peripheral circuit transistors PTR of the second stack structure SS2 may each be electrically connected to the bit line BL or the word line WL of the first stack structure SS1 through the first bonding pads BP1 and the second bonding pads BP2.

The through-via VA may include molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, similarly to the wiring layer 152 and the via 154 of the wiring structure 150 of the first stack structure SS1, and the wiring layer 182 and the via 184 of the peripheral circuit wiring structure 180 of the second stack structure SS2, but is not limited thereto.

For example, as a tapered via insulating layer is elongated in the vertical direction (the Z direction), an area of the tapered via insulating layer decreases in the horizontal direction (the X direction and Y direction), and accordingly, it is difficult to obtain a process margin of the through-via VA, and in contrast to this, even when the via insulating layer 190 having an hourglass shape is elongated in the vertical direction (the Z direction), an area of the via insulating layer 190 in the horizontal direction (the X direction and Y direction) decreases and then increases, and accordingly, the smallest area of the via insulating layer 190 in the horizontal direction (the X direction and Y direction) may be relatively greater than the smallest area of the tapered via insulating layer. Accordingly, the present disclosure may easily obtain a process margin of the through-via VA and may provide a semiconductor device with improved reliability.

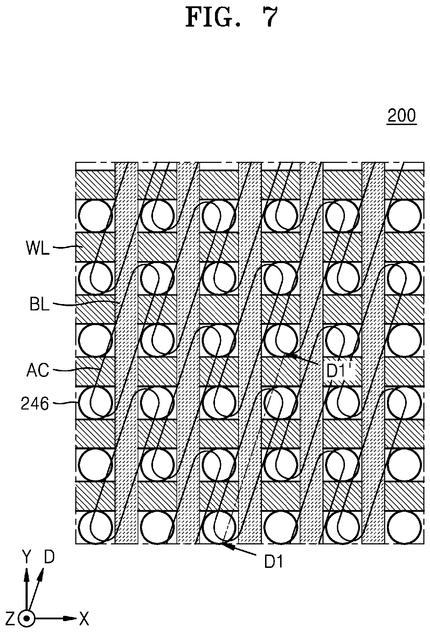

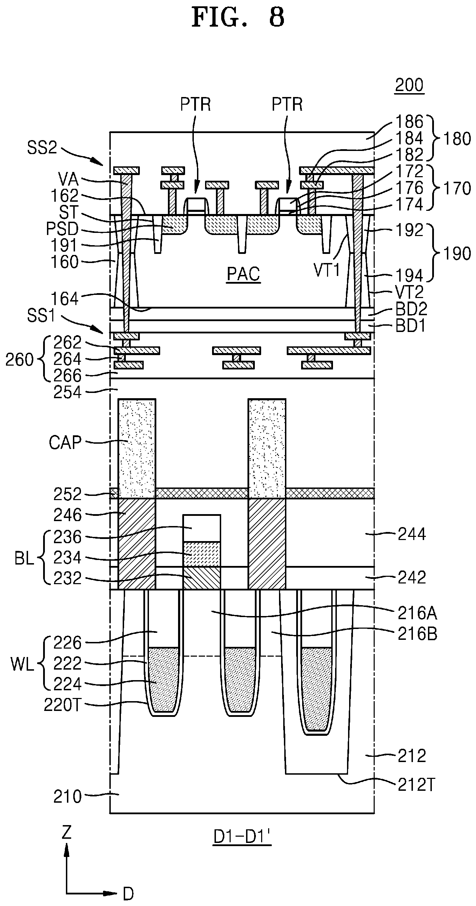

FIG. 7 is a layout diagram illustrating an example of a semiconductor device according to some implementations, and FIG. 8 is a cross-sectional view taken along line D1-D1' of FIG. 7 according to some implementations. The semiconductor device 200 described below with reference to FIG. 7 and FIG. 8 is substantially similar to the semiconductor device 100 described above, and accordingly, a difference between the semiconductor device 100 and the semiconductor device 200 is mainly described below.

In FIG. 7 and FIG. 8, the semiconductor device 200 may include a first stack structure SS1 and a second stack structure SS2, and the second stack structure SS2 may be bonded to the first stack structure SS1 by a first bonding insulating layer BD1 and a second bonding insulating layer BD2. The first stack structure SS1 may include a capacitor structure CAP on a buried channel array transistor (BCAT) structure.

A first substrate 210 may have a plurality of cell active regions AC defined by a cell device isolation layer 212.

In some implementations, the cell device isolation layer 212 may have an STI structure. For example, the cell device isolation layer 212 may include an insulating material that fills a cell device isolation trench 212T formed in the first substrate 210. The insulating material may include FSG, USG, BPSG, PSG, FOX, PE-TEOS, or TOSZ but is not limited thereto.

The plurality of cell active regions AC may each have a relatively long island shape having a short axis and a long axis. As illustrated in FIG. 7, the long axis of each of the plurality of cell active regions AC may be in a diagonal direction (a D1-D1' direction) parallel to an upper surface of the first substrate 210. In some implementations, the plurality of cell active regions AC may each have a first conductivity type. The first conductivity type may be p⁻ type (or n⁻ type).

The first substrate 210 may have a word line trench 220T extending in a first horizontal direction (the X direction). The word line trench 220T may intersect the cell active region AC and may be formed to a preset depth from an upper surface of the first substrate 210. A part of the word line trench 220T may extend into the cell device isolation layer 212, and a part of the word line trench 220T formed inside the cell device isolation layer 212 may have a bottom surface at a lower level than a part of the word line trench 220T formed inside the cell active region AC.

A first source/drain region 216A and a second source/drain region 216B may be respectively arranged on both sides of the word line trench 220T in an upper portion of the cell active region AC. The first source/drain region 216A and the second source/drain region 216B may each be an impurity region doped with an impurity having a second conductive type that is different from the first conductive type. The second conductive type may be n⁻ type (or p⁻ type).

A word line WL may be formed inside the word line trench 220T. The word line WL may include a gate insulating layer 222, a gate electrode 224, and a gate capping layer 226 sequentially formed on an inner wall of the word line trench 220T.

The gate insulating layer 222 may be conformally formed on the inner wall of the word line trench 220T with a preset thickness. The gate insulating layer 222 may be formed of at least one selected from silicon oxide, silicon nitride, silicon oxynitride, oxide/nitride/oxide (ONO), and a high-k material having a higher dielectric constant than silicon oxide. For example, the gate insulating layer 222 may have a dielectric constant of about 10 to about 25. In some implementations, the gate insulating layer 222 may be formed of HfO₂, Al₂O₃, HfAlO₃, Ta₂O₃, TiO₂, or a combination thereof but is not limited thereto.

The gate electrode 224 may fill the word line trench 220T from a bottom of the word line trench 220T to a preset height on the gate insulating layer 222. The gate electrode 224 may include a work function control layer provided on the gate insulating layer 222 and a buried metal layer filling a bottom portion of the word line trench 220T on the work function control layer. For example, the work function control layer may include a metal, such as Ti, TiN, TiAlN, TiAlC, TiAlCN, TiSiCN, Ta, TaN, TaAlN, TaAlCN, and TaSiCN, a metal nitride, or a metal carbide, and the buried metal layer may include at least one of W, WN, TiN, and TaN.

The gate capping layer 226 may fill the remaining portion of the word line trench 220T on the gate electrode 224. For example, the gate capping layer 226 may include at least one of silicon oxide, silicon oxynitride, and silicon nitride.

A bit line BL extending in the Y direction perpendicular to the X direction may be formed on the first source/drain region 216A. The bit line BL may include a bit line contact 232, a bit line conductive layer 234, and a bit line capping layer 236 sequentially stacked on the first substrate 210. For example, the bit line contact 232 may include polysilicon, and the bit line conductive layer 234 may include a metal. The bit line capping layer 236 may include an insulating material, such as silicon nitride or silicon oxynitride. Although FIG. 8 illustrates that a bottom surface of the bit line contact 232 is equal to an upper surface of the first substrate 210, the bottom surface of the bit line contact 232 may be lower than the upper surface of the first substrate 210.

In some implementations, a bit line intermediate layer may be provided between the bit line contact 232 and the bit line conductive layer 234. The bit line intermediate layer may include a metal silicide, such as tungsten silicide, or a metal nitride, such as tungsten nitride. A bit line spacer may be further formed on a sidewall of the bit line BL. The bit line spacer may include a single-layer structure or a multi-layer structure formed of an insulating material, such as silicon oxide, silicon oxynitride, or silicon nitride. Also, the bit line spacer may further include an air space.

A first interlayer insulating layer 242 may be formed on the first substrate 210, and the bit line contact 232 may pass through the first interlayer insulating layer 242 and be connected to the first source/drain region 216A. The bit line conductive layer 234 and the bit line capping layer 236 may be provided on the first interlayer insulating layer 242. A second interlayer insulating layer 244 may be provided on the first interlayer insulating layer 242 to cover a side surface of the bit line conductive layer 234 and a side surface and upper surface of the bit line capping layer 236.

A contact structure 246 may be on the second source/drain region 216B. A sidewall of the contact structure 246 may be surrounded by the first interlayer insulating layer 242 and the second interlayer insulating layer 244. In some implementations, the contact structure 246 may include a lower contact pattern, a metal silicide layer, and an upper contact pattern sequentially stacked on the first substrate 210, and a barrier layer surrounding a side and bottom surface of the upper contact pattern. In some implementations, the lower contact pattern may include polysilicon, and the upper contact pattern may include a metal material. The barrier layer may include a conductive metal nitride.

A capacitor structure CAP may be provided on the second interlayer insulating layer 244. An etching stop layer 252 having an opening may be provided on the second interlayer insulating layer 244, and a bottom portion of the capacitor structure CAP may be provided inside the opening of the etching stop layer 252. The capacitor structure CAP may be covered by a capacitor insulating layer 254.

The capacitor structure CAP may include a lower electrode electrically connected to the contact structure 246, a dielectric layer on the lower electrode, and an upper electrode on the dielectric layer. For example, the lower electrode may have a pillar shape extending in a vertical direction (the Z direction) on the contact structure 246, and the dielectric layer may have a shape extending conformally along the upper surface and sidewall of the lower electrode.

In FIG. 7, contact structures 246 may be repeatedly arranged in a first horizontal direction (the X direction) and a second horizontal direction (the Y direction), and likewise, capacitor structures CAP may also be repeatedly arranged in the first horizontal direction (the X direction) and the second horizontal direction (the Y direction) to overlap the contact structure 246 in the vertical direction (the Z direction). However, this is only an example, and the capacitor structures CAP may also be arranged in a hexagonal shape, such as a honeycomb structure. In this case, landing pads may be respectively provided between the contact structures 246 and the capacitor structures CAP.

The first stack structure SS1 may include a wiring structure 260. The wiring structure 260 may be provided above the capacitor insulating layer 254. For example, the wiring structure 260 may include a plurality of wiring layers 262, a via 264 electrically connecting the plurality of wiring layers 262 located at different vertical levels among the plurality of wiring layers 262, and an interlayer insulating layer 266 covering the plurality of wiring layers 262 and the via 264. The wiring structure 260 may be electrically connected to a word line WL or a bit line BL.

One end of the through-via VA may be electrically connected to the wiring layer 182 of the peripheral circuit wiring structure 180 in the second stack structure SS2, and the other end of the through-via VA may be electrically connected to each of the plurality of wiring layers 262 of the wiring structure 260 in the first stack structure SS1. Through the through-vias VA, a plurality of peripheral circuit transistors PTRs of the second stack structure SS2 may be electrically connected to a plurality of conductive structures of the first stack structure SS1.

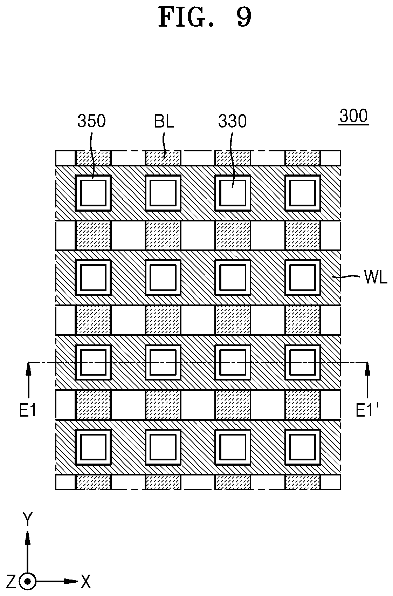

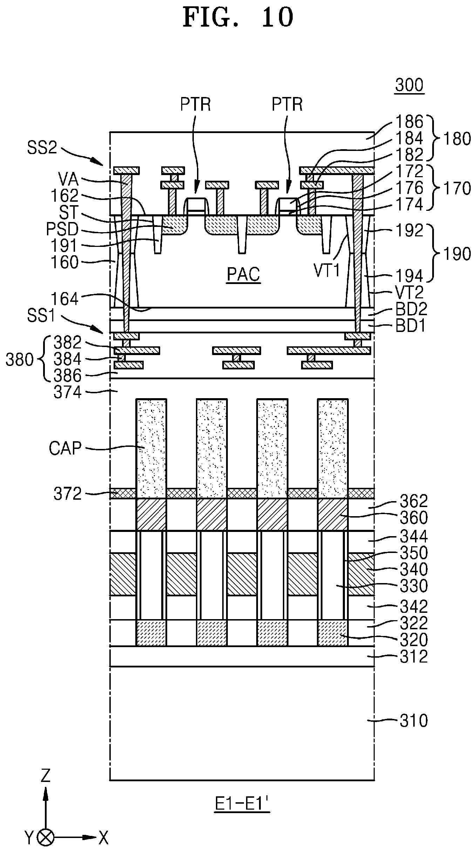

FIG. 9 is a layout diagram illustrating an example of a semiconductor device according to some implementations, and FIG. 10 is a cross-sectional view taken along line E1-E1' of FIG. 9 according to some implementations. The semiconductor device 300 described below with reference to FIG. 9 and FIG. 10 is substantially similar to the semiconductor device 100 described above, and accordingly, a difference between the semiconductor device 100 and the semiconductor device 300 is mainly described below.

In FIG. 9 and FIG. 10, a semiconductor device 300 may include a first stack structure SS1 and a second stack structure SS2, and the second stack structure SS2 may be bonded to the first stack structure SS1 by a first bonding insulating layer BD1 and a second bonding insulating layer BD2. The first stack structure SS1 may include a capacitor structure CAP on a vertical channel transistor (VCT) structure.

A lower insulating layer 312 may be provided on a substrate 310, and a plurality of first conductive lines 320 may be arranged on the lower insulating layer 312 to be spaced apart from each other in a first horizontal direction (the X direction) and to extend in a second horizontal direction (the Y direction). A plurality of first insulating patterns 322 may be arranged on the lower insulating layer 312 to fill spaces between the plurality of first conductive lines 320. The plurality of first conductive lines 320 may correspond to bit lines (BL of FIG. 9).

In some implementations, the plurality of first conductive lines 320 may each include doped polysilicon, a metal, a conductive metal nitride, a conductive metal silicide, a conductive metal oxide, or a combination thereof. For example, the plurality of first conductive lines 320 may each include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrO, RuO, or a combination thereof but are not limited thereto. The plurality of first conductive lines 320 may include a single-layer structure or a multilayer structure of the material. In some implementations, the plurality of first conductive lines 320 may each include a two-dimensional semiconductor material, and for example, the two-dimensional semiconductor material may include graphene, carbon nanotubes, or a combination thereof.

A plurality of channel layers 330 may be arranged on the plurality of first conductive lines 320 to have island shapes spaced apart from each other in a first horizontal direction (the X direction) and a second horizontal direction (the Y direction). The plurality of channel layers 330 may each have a channel width along the first horizontal direction (the X direction) and a channel height along the vertical direction (the Z direction), and the channel height may be greater than the channel width. A bottom portion of the channel layer 330 may function as a first source/drain region, an upper portion of the channel layer 330 may function as a second source/drain region, and a part of the channel layer 330 between the first source/drain region and the second source/drain region may function as a channel region. A vertical channel transistor may refer to a structure in which a channel length of the channel layer 330 extends in the vertical direction (the Z direction) from the substrate 310.

In some implementations, the channel layer 330 may include an oxide semiconductor, and for example, the oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, In_{y}Ga_{y}O, or a combination thereof. The channel layer 330 may include a single-layer structure or a multi-layer structure of an oxide semiconductor. In some implementations, the channel layer 330 may have a band gap energy greater than a band gap energy of silicon. The channel layer 330 may be polycrystalline or amorphous but is not limited thereto. In some implementations, the channel layer 330 may include a two-dimensional semiconductor material, and for example, the two-dimensional semiconductor material may include graphene, carbon nanotubes, or a combination thereof.

In some implementations, a gate electrode 340 may surround a sidewall of the channel layer 330 and extend in the first horizontal direction (the X direction). In some implementations, the gate electrode 340 may be a GAA-type gate electrode that surrounds the entire sidewall of the channel layer 330, but this is an example, and the present disclosure is not limited to the illustration. The gate electrode 340 may correspond to a word line (WL of FIG. 9).

In other implementations, the gate electrode 340 may be a dual-gate-type gate electrode and may include, for example, a first sub-gate electrode facing a first sidewall of the channel layer 330 and a second sub-gate electrode facing a second sidewall of the channel layer 330 opposite to the first sidewall. In some implementations, the gate electrode 340 may be a single-gate-type gate electrode that covers only the first sidewall of the channel layer 330 and extends in the first horizontal direction (the X direction).

The gate electrode 340 may include doped polysilicon, a metal, a conductive metal nitride, a conductive metal silicide, a conductive metal oxide, or a combination thereof. For example, the gate electrode 340 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof but is not limited thereto.

A gate insulating layer 350 may surround a sidewall of the channel layer 330 and may be provided between the channel layer 330 and the gate electrode 340. In some implementations, the gate insulating layer 350 may include a silicon oxide layer, a silicon oxynitride layer, a high-k dielectric layer having a higher dielectric constant than the silicon oxide layer, or a combination thereof. The high-k dielectric layer may include a metal oxide or a metal oxynitride. For example, a high-k dielectric layer forming the gate insulating layer 350 may include HfO₂, HfSiO, HfSiON, HfTaO, HfTiO, HfZrO, ZrO₂, Al₂O₃, or a combination thereof but is not limited thereto.

A first buried insulating layer 342 surrounding lower sidewalls of the plurality of channel layers 330 may be provided on a plurality of first insulating patterns 322, and a second buried insulating layer 344 surrounding the lower sidewalls of the plurality of channel layers 330 and covering the gate electrode 340 may be provided on the first buried insulating layer 342.

A plurality of capacitor contacts 360 may be respectively provided on the plurality of channel layers 330. The plurality of capacitor contacts 360 may have a matrix form to vertically overlap the plurality of channel layers 330 and to be spaced apart from each other in the first horizontal direction (the X direction) and the second horizontal direction (the Y direction). The plurality of capacitor contacts 360 may each include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrO, RuO, or a combination thereof but are not limited thereto. An upper insulating layer 362 may surround sidewalls of the plurality of capacitor contacts 360 on the second buried insulating layer 344.

An etch stop layer 372 having a plurality of openings may be provided on the upper insulating layer 362, and bottom portions of the plurality of capacitor structures CAP may be respectively arranged inside the plurality of openings of the etch stop layer 372. The plurality of capacitor structures CAP may be covered by a capacitor insulating layer 374.

The plurality of capacitor structures CAP may each include a lower electrode electrically connected to each of the plurality of capacitor contacts 360, a dielectric layer on the lower electrode, and an upper electrode on the dielectric layer. For example, the lower electrode may have a pillar shape extending in the vertical direction (the Z direction) on the capacitor contact 360, and the dielectric layer may have a shape conformally extending along an upper surface and sidewall of the lower electrode.

The first stack structure SS1 may include a wiring structure 380. The wiring structure 380 may be provided on the capacitor insulating layer 374. For example, the wiring structure 380 may include a plurality of wiring layers 382, a via 384 electrically connecting the plurality of wiring layers 382, which are located at different vertical levels, to each other, and an interlayer insulating layer 386 covering the plurality of wiring layers 382 and the via 384. The wiring structure 380 may be electrically connected to a word line WL or a bit line BL.

One end of the through-via VA may be electrically connected to a wiring layer 182 of the peripheral circuit wiring structure 180 of the second stack structure SS2, and the other end of the through-via VA may be electrically connected to the wiring layer 382 of the wiring structure 380 of the first stack structure SS1. A plurality of peripheral circuit transistors PTR of the second stack structure SS2 may be respectively and electrically connected to a plurality of conductive structures of the first stack structure SS1 through the through-via VA.

Herein, although the first stack structure SS1 of the semiconductor device 100, the first stack structure SS1 of the semiconductor device 200, and the first stack structure SS1 of the semiconductor device 300 are exemplified as the first stack structure SS1 bonded to the second stack structure SS2, this is an example, and the present disclosure is not limited thereto and may employ first stack structures of various types in addition to the first stack structures SS1. For example, the first stack structure SS1 may include a plurality of flash memory cells and may include a memory cell array composed of the plurality of flash memory cells, and the memory cell array constituting the first stack structure SS1 may also include a plurality of NAND strings.

Also, herein, the second stack structure SS2 is not limited to a front side power delivery network (FSPDN) that supplies power to a first surface 162 of the second substrate 160, and may also include a back side power delivery network (BSPDN) that supplies power to a second surface 164 of the second substrate 160. For example, a wiring structure 150 may be provided under a plurality of word lines WL and a plurality of bit lines BL in a first stack structure SS1, a first substrate 110 may be arranged over a plurality of word lines WL and a plurality of bit lines BL, and a second stack structure SS2 bonded to the first stack structure SS1 may be provided under the first stack structure SS1. In this case, a part of the peripheral circuit wiring structure 180 for supplying power may be provided on the second surface 164 of the second substrate 160 and may be electrically connected to the through-via VA. When the second stack structure SS2 is under the first stack structure SS1, a through-via hole for forming the through-via VA in the second surface 164 of the second substrate 160 may be formed by etching, and accordingly, the through-via VA may have a shape in which a horizontal area decreases from the second surface 164 of the second substrate 160 toward the first surface 162.

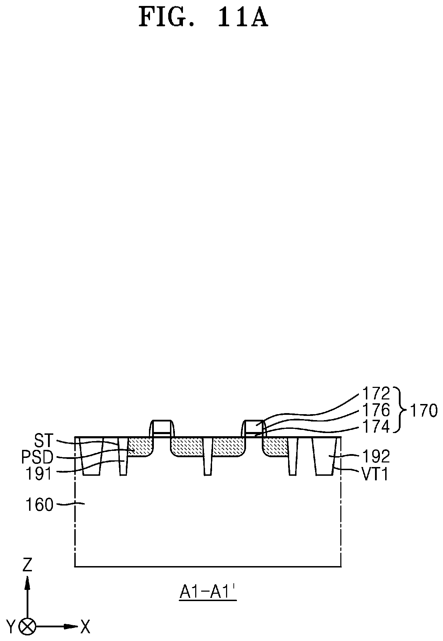

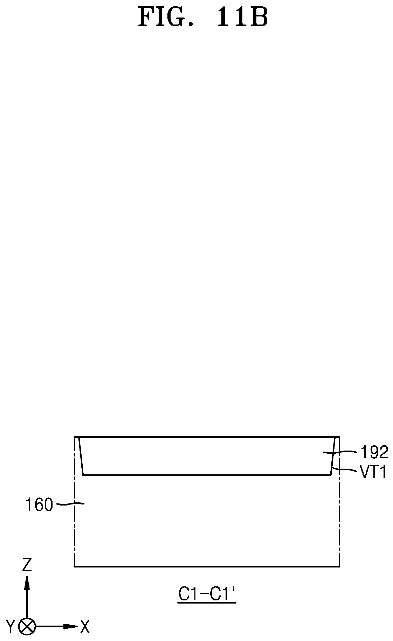

FIG. 11A to FIG. 17B are views sequentially illustrating an example of a method of manufacturing a semiconductor device according to some implementations. Specifically, FIGS. 11A, 12A, 13A, 14A, 15A, 16A, and 17A are cross-sectional views taken along line A1-A1' of FIG. 3 according to some implementations, and FIGS. 11B, 12B, 13B, 14B, 15B, 16B, and 17B are cross-sectional views taken along the line C1-C1' of FIG. 3 according to some implementations.

In FIG. 11A and FIG. 11B, a device isolation trench ST may be formed in the first surface 162 of the second substrate 160 to define a plurality of active regions PAC. In order to form the device isolation trench ST, an etching process may be performed on the first surface 162 of the second substrate 160, and the etching process may be an anisotropic etching process, for example, a dry etching process using plasma.

In some implementations, a first via insulating layer trench VT1 may be formed together with the device isolation trench ST. The first via insulating layer trench VT1 may be formed simultaneously with the device isolation trench ST in a process of forming the device isolation trench ST. In some implementations, the first via insulating layer trench VT1 may have the same depth as a depth of the device isolation trench ST formed in the first surface 162 of the second substrate 160. For example, the first via insulating layer trench VT1 and the device isolation trench ST may all have depths of about 100 nm to about 500 nm in the first surface 162 of the second substrate 160.

Thereafter, in order to form a device isolation layer 191 and a first via insulating layer 192, the inside of each of the device isolation trench ST and the first via insulating layer trench VT1 may be filled with an insulating material. The insulating material may include FSG, USG, BPSG, PSG, FOX, PE-TEOS, or TOSZ but is not limited thereto.

Thereafter, a peripheral circuit transistor PTR, which includes an ion implantation region PSD and a gate structure 170 including a gate electrode 172, a gate insulating layer 174, and a gate spacer 176, may be formed on a second substrate 160 on which the device isolation layer 191 and the first via insulating layer 192 are formed.

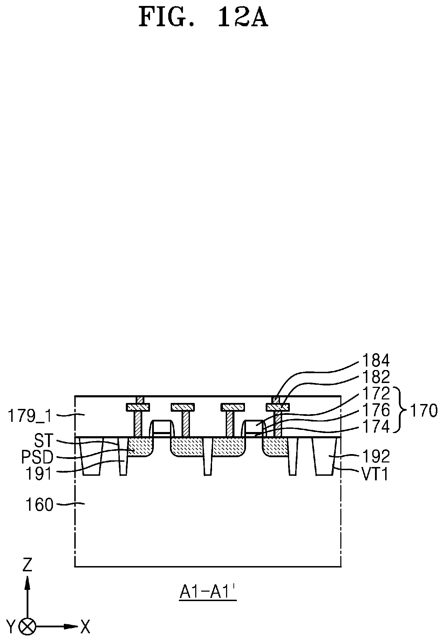

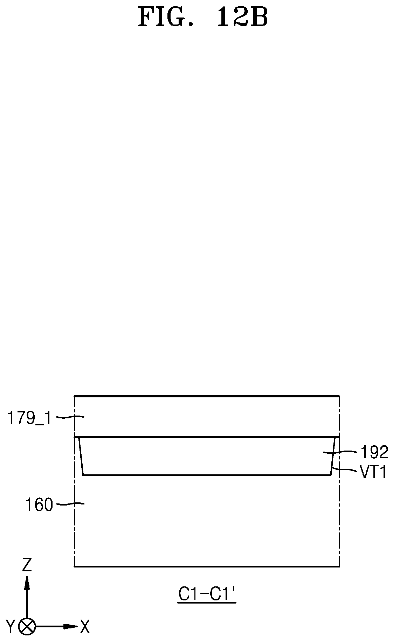

In FIG. 12A and FIG. 12B, a peripheral circuit wiring structure 180 covering the peripheral circuit transistor PTR may be formed on the second substrate 160 on which the peripheral circuit transistor PTR is formed. The peripheral circuit wiring structure 180 may include a plurality of wiring layers 182, a plurality of vias 184 electrically connecting between the peripheral circuit transistor PTR and the plurality of wiring layers 182 or between the wiring layers 182 located at different vertical levels, and a peripheral circuit insulating layer 186 covering the plurality of wiring layers 182 and the plurality of vias 184.

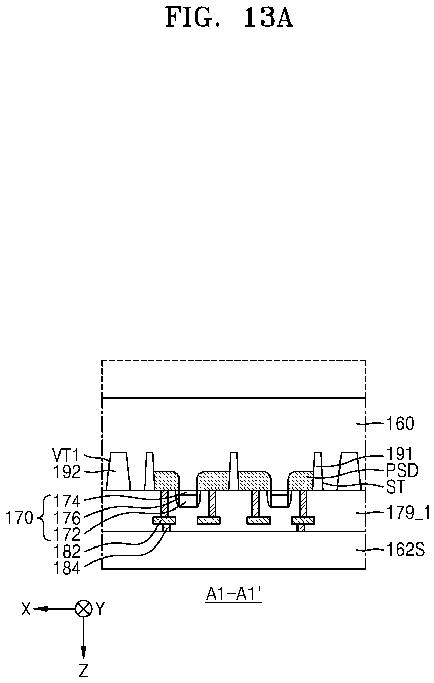

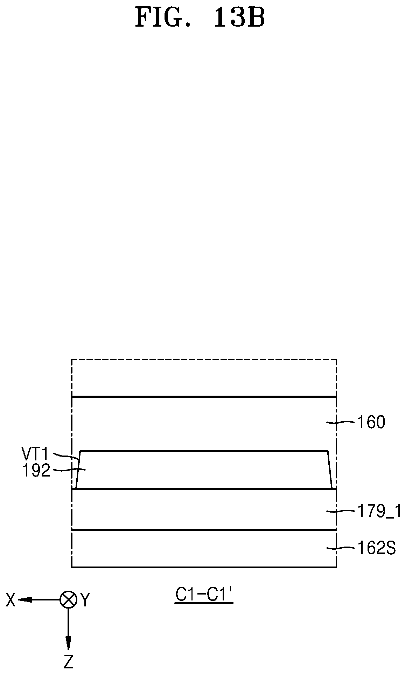

In FIG. 13A and FIG. 13B, a resulting device of FIG. 12A and FIG. 12B may be rotated such that the first surface 162 of the second substrate 160 faces downward and the second surface 164 faces upward. In this case, a support substrate 162S may be bonded onto the first surface 162 of the second substrate 160.

In order to reduce a thickness of the second substrate 160 in a vertical direction (the Z direction), grinding, chemical mechanical polishing (CMP), a dry etching process, and/or a wet etching process may be performed on the second surface 164 of the second substrate 160.

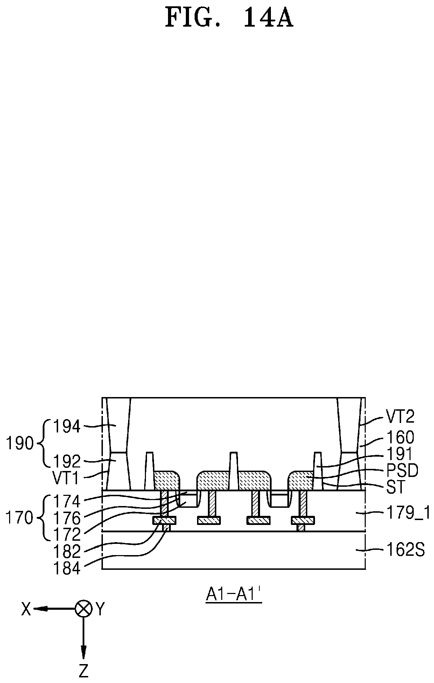

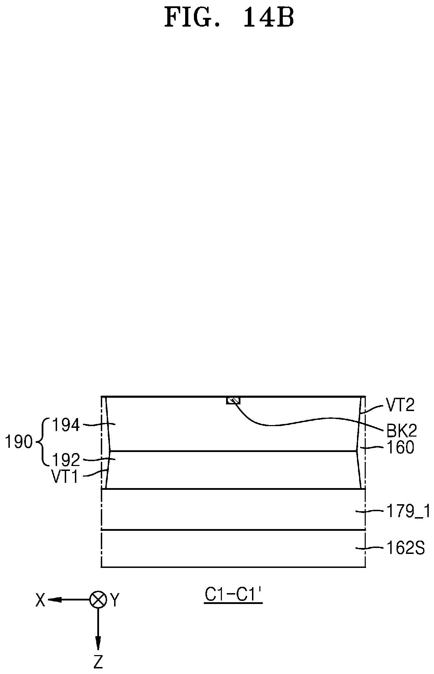

In FIG. 14A and FIG. 14B, a second via insulating layer trench VT2 may be formed on the resulting device of FIG. 13A and FIG. 13B to form a second via insulating layer 194. An etching process may be performed on the second surface 164 of the second substrate 160 to form the second via insulating layer trench VT2, and the etching process may be an anisotropic etching process, for example, a dry etching process. For example, the second via insulating layer trench VT2 may have a depth of about 500 nm to about 900 nm which is formed in the second surface 164 of the second substrate 160.

Thereafter, the inside of the second via insulating layer trench VT2 may be filled with an insulating material to form the second via insulating layer 194. The insulating material may include FSG, USG, BPSG, PSG, FOX, PE-TEOS, or TOSZ but is not limited thereto.

Because the first via insulating layer trench VT1 and the second via insulating layer trench VT2 are formed by etching in an etching process, the first via insulating layer trench VT1 and the second via insulating layer trench VT2 may each have an inclined sidewall, the first via insulating layer 192 and the second via insulating layer 194 may each have a tapered shape, and the via insulating layer 190 may have an hourglass shape.

After the second via insulating layer 194 is formed, a second bonding key BK2 may be formed on the second via insulating layer 194. The second bonding key BK2 may be for alignment with a first bonding key (BK1 of FIG. 4C) of a first stack structure (SS1 of FIG. 4C). In order to form the second bonding key BK2, a part of the second via insulating layer 194, which is at a position corresponding to the first bonding key (BK1 in FIG. 4C) of the second via insulating layer 194, may be etched, and a material different from a material of the second via insulating layer 194 may be filled into a space formed by etching a part of the second via insulating layer 194. Alternatively, a groove itself formed by etching a part of the second via insulating layer 194 may be used as the second bonding key BK2.

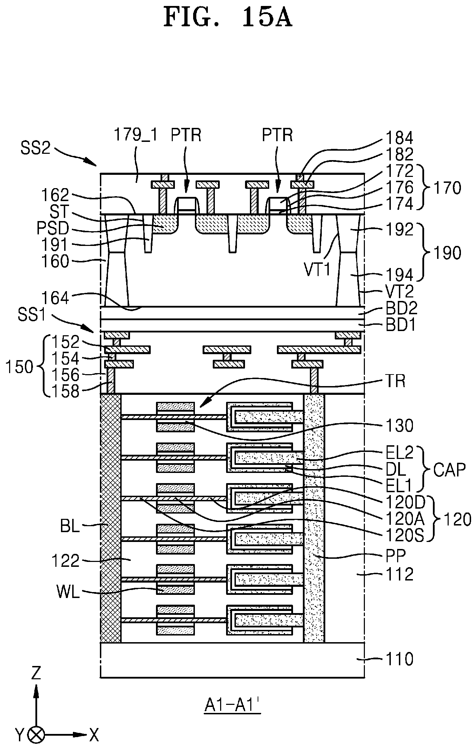

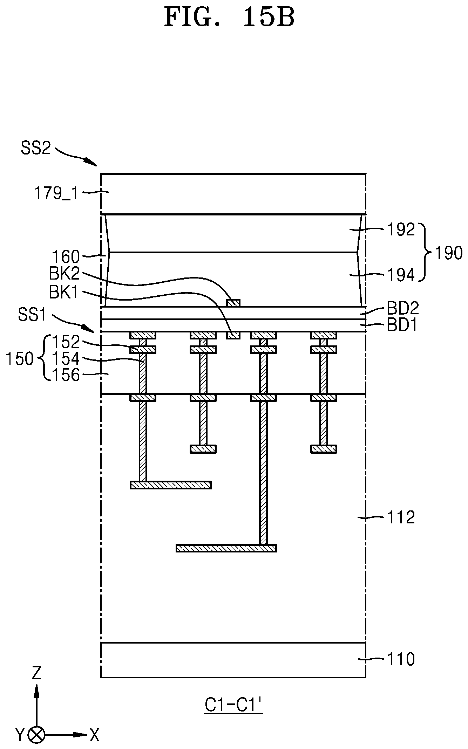

In FIG. 15A and FIG. 15B, a process of bonding the second stack structure SS2 to the first stack structure SS1 formed through a separate process may be performed. After a first bonding insulating layer BD1 is formed on an upper surface of a wiring structure 150 of the first stack structure SS1 and a second bonding insulating layer BD2 is formed on the second surface 164 of the second substrate 160 of the second stack structure SS2, the first bonding insulating layer BD1 may be directly bonded to the second bonding insulating layer BD2, and accordingly, the first stack structure SS1 is bonded to the second stack structure SS2.

For example, in order to bond the first bonding insulating layer BD1 to the second bonding insulating layer BD2, the first stack structure SS1 and the second stack structure SS2 are aligned such that the first bonding insulating layer BD1 faces the second bonding insulating layer BD2, a certain pressure is applied to the first stack structure SS1 and the second stack structure SS2 such that the first bonding insulating layer BD1 comes into contact with the second bonding insulating layer BD2, and then, the first bonding insulating layer BD1 and the second bonding insulating layer BD2 may be annealed in a state where the first stack structure SS1 is in contact with the second stack structure SS2, and accordingly, the first bonding insulating layer BD1 may be chemically bonded to the second bonding insulating layer BD2. In some implementations, in order to strengthen a bonding strength between the first bonding insulating layer BD1 and the second bonding insulating layer BD2, a process of planarizing surfaces of the first bonding insulating layer BD1 and the second bonding insulating layer BD2 may be further performed.

In a process of aligning the first stack structure SS1 and the second stack structure SS2 to bond the first stack structure SS1 to the second stack structure SS2, the precise alignment may be performed because a distance between the first bonding key BK1 and the second bonding key BK2 is relatively short, and a method of manufacturing a semiconductor device with relatively improved reliability may be provided.

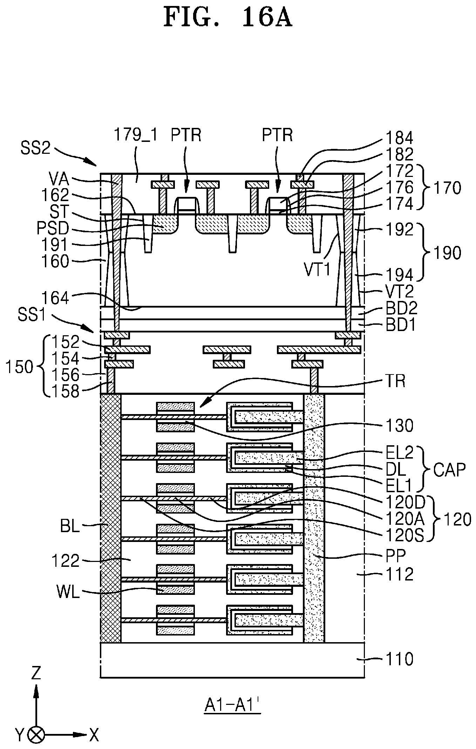

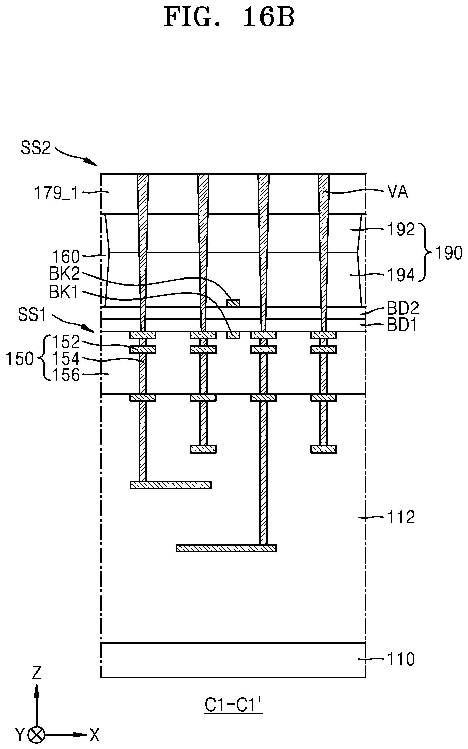

In FIG. 16A and FIG. 16B, the through-via VA, which sequentially passes through a peripheral circuit insulating layer 179_1, the first via insulating layer 192, the second via insulating layer 194, the second bonding insulating layer BD2, and the first bonding insulating layer BD1 in a vertical direction (the Z direction), may be formed. In order to form the through-via VA, a through-via hole, which penetrates the peripheral circuit insulating layer 179_1, the first via insulating layer 192, the second via insulating layer 194, the second bonding insulating layer BD2, and the first bonding insulating layer BD1 in the vertical direction (the Z direction), may be formed through an etching process. The etching process for forming the through-via hole may be an anisotropic etching process, for example, a dry etching process. The through-via hole may be filled with a conductive material to form the through-via, and the conductive material may include, for example, molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof.

According to some implementations, the via insulating layer 190 having an hourglass shape may be provided, a process margin of the through-via hole may correspond to a horizontal area of a contact surface between the first via insulating layer 192 and the second via insulating layer 194, and thus, the process margin may be easily obtained, and also, a method of manufacturing a semiconductor device with relatively improved reliability may be provided.

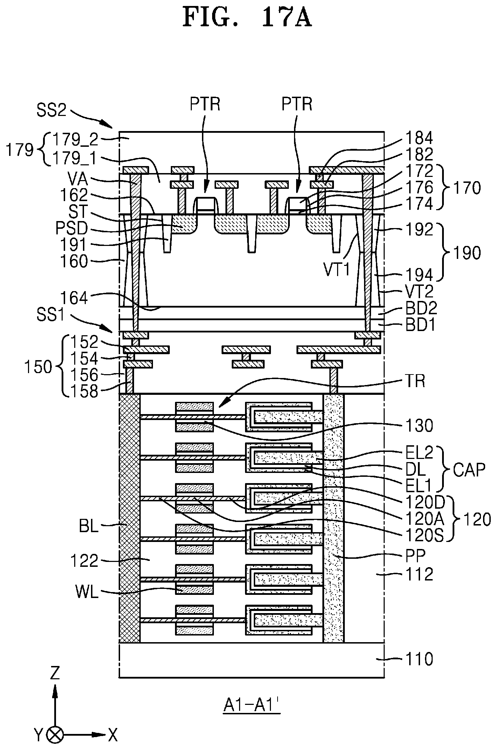

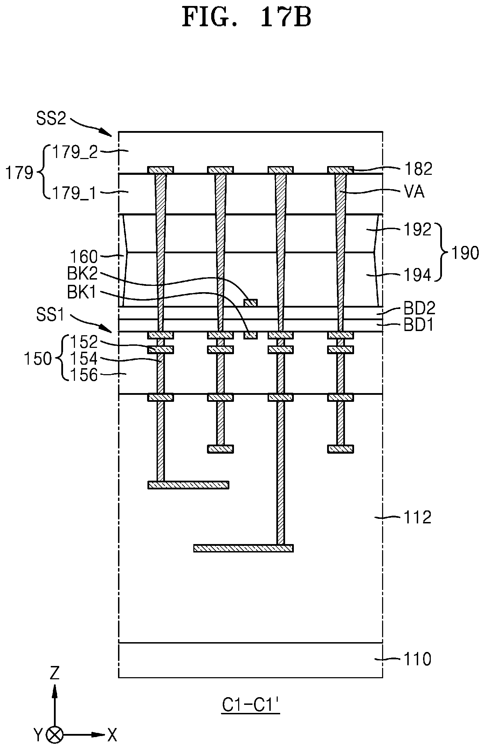

In FIG. 17A and FIG. 17B, the wiring layer 182 electrically connecting the through-via VA to the peripheral circuit transistor PTR, the plurality of vias 184 connected to the wiring layer 182, and a peripheral circuit insulating layer 179_2 covering the wiring layer 182 and the plurality of vias 184 may be formed.

FIG. 18A to FIG. 19B are views sequentially illustrating an example of a method of manufacturing a semiconductor device according to some implementations. Specifically, a manufacturing process according to some implementations may be performed after the manufacturing process described with reference to FIG. 14A and FIG. 14B is described below with reference to FIG. 18A to FIG. 19B.

In FIG. 18A and FIG. 18B, a process of bonding a first stack structure SS1 to a second stack structure SS2 formed through a separate process may be performed. A plurality of first bonding pads BP1 and a first bonding insulating layer BD1 surrounding sidewalls of the plurality of first bonding pads BP1 may be formed on an upper surface of a wiring structure 150 of the first stack structure SS1, and a plurality of second bonding pads BP2 and a second bonding insulating layer BD2 surrounding sidewalls of the plurality of second bonding pads BP2 may be formed on a second surface 164 of a second substrate 160 of the second stack structure SS2. For example, the first bonding insulating layer BD1 and the second bonding insulating layer BD2 may be first formed, and then a plurality of local regions may be removed to fill the plurality of local regions with a conductive material, for example, copper, aluminum, or tungsten, and accordingly, the plurality of first bonding pads BP1 and the plurality of second bonding pads BP2 may be formed.

Thereafter, the plurality of first bonding pads BP1 may be directly bonded to the plurality of second bonding pads BP2, and the first bonding insulating layer BD1 may be directly bonded to the second bonding insulating layer BD2, and accordingly, the first stack structure SS1 may be bonded to the second stack structure SS2. For example, in order to bond the first bonding insulating layer BD1 to the second bonding insulating layer BD2 and the plurality of first bonding pads BP1 to the plurality of second bonding pads BP2, the first stack structure SS1 may be aligned with the second stack structure SS2 such that the first bonding insulating layer BD1 faces the second bonding insulating layer BD2 and the plurality of first bonding pads BP1 face the plurality of second bonding pads BP2, and a certain pressure may be applied to the first stack structure SS1 and the second stack structure SS2 such that the first bonding insulating layer BD1 comes into contact with the second bonding insulating layer BD2 and the plurality of first bonding pads BP1 respectively come into contact with the plurality of second bonding pads BP2, and then the first stack structure SS1 and the second stack structure SS2 may be annealed, and accordingly, the first bonding insulating layer BD1 may be chemically bonded to the second bonding pads (BP2), and the plurality of first bonding pads BP1 may be chemically bonded to the plurality of second bonding pads BP2. In some implementations, in order to increase a bonding strength between the plurality of first bonding pads BP1 and the plurality of second bonding pads BP2, a process of treating the exposed surfaces of the plurality of first bonding pads BP1 and the plurality of second bonding pads BP2 with hydrogen plasma may be further performed.

Thereafter, a through-via VA passing through a first via insulating layer 192 and a second via insulating layer 194 may be formed. Because a process of manufacturing the through-via VA may be performed similarly to the process described above with reference to FIG. 16A and FIG. 16B, detailed descriptions thereof are omitted. However, the present disclosure is not limited to forming the through-via VA after a process of bonding the first stack structure SS1 to the second stack structure SS2 is performed, and a process of bonding the first stack structure SS1 to the second stack structure SS2 through bonding of the plurality of first bonding pads BP1 and the plurality of second bonding pads BP2 and bonding of the first bonding insulating layer BD1 and the second bonding insulating layer BD2 may also be performed after the through-via VA is first formed on the second stack structure SS2.

In some implementations, an interlayer wiring layer may be formed on the second surface 164 of the second substrate 160, and also, the plurality of second bonding pads BP2 and the second bonding insulating layer BD2 may be formed on the interlayer wiring layer. Conductive components in the interlayer wiring layer may respectively and electrically connect the through-via VA to the plurality of second bonding pads BP2.

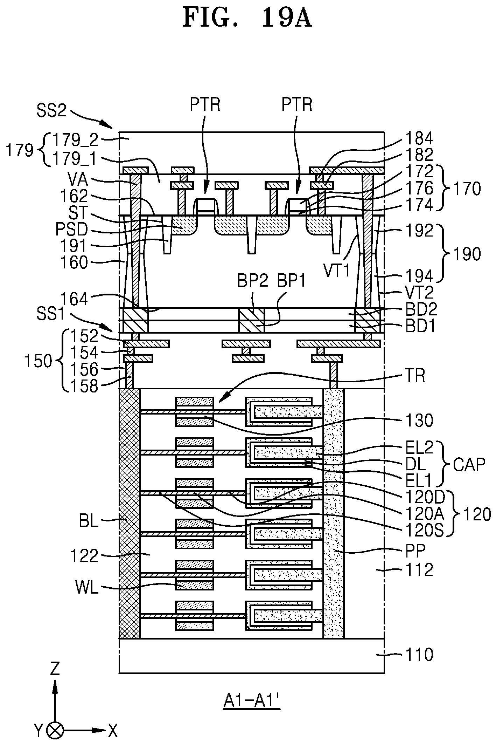

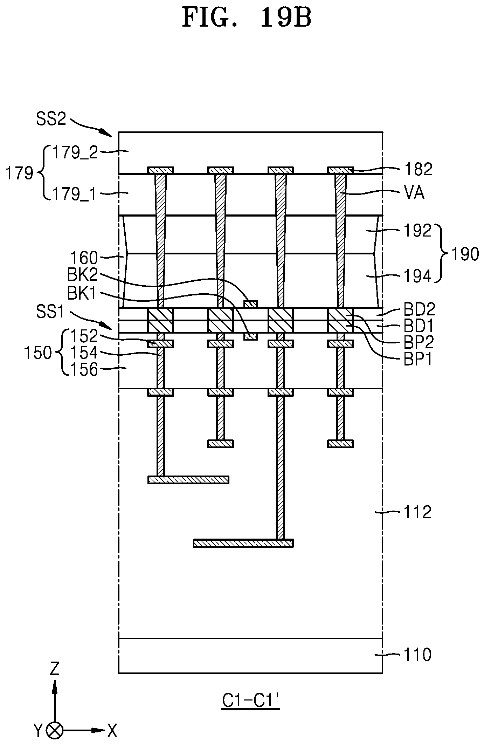

In FIG. 19A and FIG. 19B, a wiring layer 182 electrically connecting the through-via VA to the peripheral circuit transistor PTR, a via 184 connected to the wiring layer 182, and a peripheral circuit insulating layer 179_2 covering the wiring layer 182 and the via 184 may be formed.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device (100) comprising:
a first stack structure (SS1) including a first substrate (110), and a plurality of memory cells (MC) on the first substrate (110); and
a second stack structure (SS2) including a second substrate (160) overlapping the first substrate (110) in a vertical direction (Z), and a plurality of peripheral circuit transistors (PTR) on the second substrate (160),
wherein the second stack structure (SS2) comprises:
a first via insulating layer (192) passing through a part of the second substrate (160) in the vertical direction (Z);
a second via insulating layer (194) overlapping at least a portion of the first via insulating layer (192) in the vertical direction (Z) and passing through other portions of the second substrate (160) in the vertical direction (Z); and
a conductive through-via (VA) passing through the first via insulating layer (192) and the second via insulating layer (194) in the vertical direction (Z).

2. The semiconductor device (100) of claim 1,
wherein a first horizontal width (w1) of the first via insulating layer (192) decreases towards the second via insulating layer (194), and
wherein a second horizontal width (w2) of the second via insulating layer (194) decreases towards the first via insulating layer (192).

3. The semiconductor device (100) of claim 2, wherein a smallest value of the first horizontal width (w1) of the first via insulating layer (192) is equal to a smallest value of the second horizontal width (w2) of the second via insulating layer (194).

4. The semiconductor device (100) of any preceding claim, further comprising:
a device isolation layer (191) in a device isolation trench (ST) in the second substrate (160) adjacent to the first via insulating layer (192) in a horizontal direction (X, Y),
wherein the first via insulating layer (192) has a same vertical length as the device isolation layer (191).

5. The semiconductor device (100) of claim 4, wherein the first via insulating layer (192) includes a same material as the device isolation layer (191).

6. The semiconductor device (100) of any preceding claim, wherein the first via insulating layer (192) and the second via insulating layer (194) include silicon nitride, silicon oxide, or a combination thereof.

7. The semiconductor device (100) of any preceding claim, further comprising:
a first bonding key (BK1) on the first stack structure (SS1); and
a second bonding key (BK2) on the second stack structure (SS2), at least partially overlapping the first bonding key (BK1) in the vertical direction (Z), and facing the first bonding key (BK1),
wherein the second bonding key (BK2) is on the second via insulating layer (194).

8. The semiconductor device (100) of any preceding claim, further comprising:
a first bonding insulating layer (BD1) on the first stack structure (SS1); and
a second bonding insulating layer (BD2) on the second stack structure (SS2),
wherein the first bonding insulating layer (BD1) and the second bonding insulating layer (BD2) are between the first stack structure (SS1) and the second stack structure (SS2) bonding the first stack structure (SS1) to the second stack structure (SS2), and
the conductive through-via (VA) passes through the first bonding insulating layer (BD1) and the second bonding insulating layer (BD2) in the vertical direction (Z).

9. The semiconductor device (100) of any preceding claim, further comprising:
a wiring structure (150) electrically connected to the plurality of memory cells (MC) on the first stack structure (SS1); and
a peripheral circuit wiring structure (180) electrically connected to the peripheral circuit transistors (PTR) on the second stack structure (SS2),
wherein the conductive through-via (VA) electrically connects the peripheral circuit wiring structure(180) to the wiring structure (150).

10. The semiconductor device (100) of any preceding claim,
wherein the second substrate (160) has a first surface (162) on which the first via insulating layer (192) is arranged, and a second surface (164) opposite to the first surface (162) and upon which the second via insulating layer (194) is arranged, and
wherein each of the first via insulating layer (192) and the second via insulating layer (194) has a sidewall having a slope less than a sidewall of the conductive through-via (VA) with respect to the second surface (164) of the second substrate (160).

11. A semiconductor device (100) comprising:
a first stack structure (SS1) including a first substrate (110), and a plurality of memory cells (MC) on the first substrate (110); and
a second stack structure (SS2) including a second substrate (160) overlapping the first substrate (110) in a vertical direction (Z), and a plurality of peripheral circuit transistors (PTR) on the second substrate (160),
wherein the second stack structure (SS2) comprises:
a first via insulating layer (192) on a first surface (162) of the second substrate (160);
a second via insulating layer (194) in contact with the first via insulating layer (192) and arranged on a second surface (164) of the second substrate (160) opposite to the first surface (162);
a conductive through-via (VA) passing through the first via insulating layer (192) and the second via insulating layer (194) in the vertical direction (Z); and
a peripheral circuit wiring structure (180) electrically connecting the plurality of peripheral circuit transistors (PTR) to the conductive through-via (VA),
wherein a first horizontal width (w1) of the first via insulating layer (192) decreases towards the second via insulating layer (194), and
wherein a second horizontal width (w2) of the second via insulating layer (194) decreases towards the first via insulating layer (192).

12. The semiconductor device (100) of claim 11, wherein the first stack structure (SS1) comprises:
a semiconductor pattern (120) extending in a first horizontal direction (X) on the first substrate (110);
a word line (WL) surrounding the semiconductor pattern (120) and extending in a second horizontal direction (Y) intersecting the first horizontal direction (X);
a bit line (BL) in contact with a first end portion of the semiconductor pattern (120) and extending in the vertical direction (Z); and
a cell capacitor (CAP) in contact with a second end portion opposite to the first end portion of the semiconductor pattern (120).

13. The semiconductor device (100) of claim 12,
wherein the cell capacitor (CAP) comprises a first electrode (EL1), a capacitor dielectric layer (DL), and a second electrode (EL2),
wherein the first electrode (EL1) is electrically connected to the semiconductor pattern (120) and has an internal space extending in the first horizontal direction (X),
wherein the capacitor dielectric layer (DL) is conformally arranged along an inner wall of the internal space, and
wherein the second electrode (EL2) is in the internal space in which the capacitor dielectric layer (DL) is arranged.

14. The semiconductor device (100) of claim 11, wherein the first stack structure (SS1) comprises:
a device isolation layer (212) in a device isolation trench (212T) in the first substrate (110) to define a plurality of active regions (AC) on the first substrate (110);
a word line (WL) extending in a first horizontal direction (X) on the first substrate (110);
a bit line (BL) extending in a second horizontal direction (Y) intersecting the first horizontal direction (X) on the first substrate (110) and connected to a first source/drain region (216A) arranged on a first side of the word line (WL) among the plurality of active regions (AC);
a contact structure (246) connected to a second source/drain region (216B) arranged on a second side of the word line (WL) among the plurality of active regions (AC); and
a capacitor structure (CAP) electrically connected to the contact structure (246).

15. The semiconductor device (100) of claim 14,
wherein the bit line (BL) includes a bit line contact (232), a bit line conductive layer (234), and a bit line capping layer (236) sequentially stacked on the first substrate,
wherein the bit line contact (232) includes a semiconductor material,
wherein the bit line conductive layer (234) includes a metal, and
wherein the bit line capping layer (236) includes an insulating material.
